# EUROPEAN PATENT SPECIFICATION

(11) **EP 2 767 337 B1**
(45) Date of publication and mention of the grant of the patent: **02.11.2016**
(21) Application number: 13155174.9
(22) Date of filing: 14.02.2013
(51) Int. Cl.: C23C 16/442, C23C 16/455, C23C 16/04, C23C 16/40, C23C 16/16, B01J 37/14, B01J 29/06, B01J 29/072, B01J 37/02, B01J 29/064

(54) **Method and apparatus for fabricating solid support metal catalyst composites**
Verfahren und Vorrichtung zum Herstellen von Verbundstoffkatalysatoren basierend auf Metall auf festem Trägermaterial
Procédé et dispositiv pour fabriquer Composites de catalyseur métallique sur support solide

(43) Date of publication of application: 20.08.2014
(73) Proprietor: Directa Plus S.p.A., 22074 Lomazzo (CO) (IT)
(72) Inventor: Cesareo, Giulio, Dr., 22100 Como (CO) (IT); Kasper, Michael, 89257 Illertissen (DE); Weinberger, Manuel, Dr., 89073 Ulm (DE); Dreer, Christian, 89077 Ulm (DE)
(74) Representative: Cremer, Christian

(56) References cited:
- US-A- 5 876 793
- LI J ET AL: "Highly dispersed Pt nanoparticle catalyst prepared by atomic layer deposition", APPLIED CATALYSIS B: ENVIRONMENTAL, ELSEVIER, AMSTERDAM, NL, vol. 97, no. 1-2, 9 June 2010 (2010-06-09) , pages 220-226, XP027057416, ISSN: 0926-3373 [retrieved on 2010-04-14]
- KING ET AL: "Atomic layer deposition on particles using a fluidized bed reactor with in situ mass spectrometry", SURFACE AND COATINGS TECHNOLOGY, ELSEVIER, AMSTERDAM, NL, vol. 201, no. 22-23, 9 August 2007 (2007-08-09), pages 9163-9171, XP022191954, ISSN: 0257-8972, DOI: 10.1016/J.SURFCOAT.2007.05.002
- OKAMOTO Y ET AL: "STRUCTURE OF INTRAZEOLITE MOLYBDENUM OXIDE CLUSTERS AND THEIR CATALYSIS OF THE OXIDATION OF ETHYL ALCOHOL", PHYSICAL CHEMISTRY CHEMICAL PHYSICS, ROYAL SOCIETY OF CHEMISTRY, CAMBRIDGE, GB, vol. 4, no. 12, 15 June 2002 (2002-06-15), pages 2852-2862, XP001184424, ISSN: 1463-9076, DOI: 10.1039/B108639C
- T. BEIN ET AL: "Characterization of a new iron-on-zeolite Y Fischer-Tropsch catalyst", THE JOURNAL OF PHYSICAL CHEMISTRY, vol. 90, no. 20, 1 September 1986 (1986-09-01), pages 4851-4856, XP055001260, ISSN: 0022-3654, DOI: 10.1021/j100411a027

## Description

This invention relates to a production process and an apparatus for production of catalytically active metal composites comprising a solid support material. The metal composite can be designed with a combination of metallic or a combination of metallic and non-metallic materials. The activation of at least one chemical reaction like a synthesis reaction, a molecular decomposition or an oxidation reaction can be facilitated. The production process and the apparatus provide a good quality of a catalyst, which can be used for an efficient conversion of starting materials.

### Background art

Porous materials like zeolites and metal carbonyls as starting materials for production of catalyst materials are described in GB 364 586 A (assignor: I. G. Farbenindustrie AG; filing date: September 29th 1930) and in GB 937 749 A (assignor: Union Carbide Corporation; filing date: September 23rd 1959). The process comprises thermal decomposition of the metal carbonyl. Before the metal deposition, zeolite material is activated by driving off all of the adsorbed water. Hydrogen was added in order to improve the decomposition of the metal carbonyls. Similar aspects are described for the production of iron group metal catalysts in US 3 013 990 A (inventor: D. W. Breck et al.; filing date: September 11th 1961).

Several other approaches for the production of metallic films on different porous substrates using metal carbonyls are discussed in the patents US 3 075 494 A (assignor: H. A. Toulmin JR; filing date: February 19th 1960), US 3 158 499 A (assignor: W. C Jenkin; filing date: July 7th 1960), and US 3 998 758 A (assignor: R. A. Clyde; filing date: August 18th 1975). Metals are typically deposited by heating the substrates for thermal decomposition of the metal carbonyls. Metal carbonyls are also decomposed by heat in the gas phase.

In US 5 314 727 (assignor: Minnesota Mining & Mfg. Co./Regents of the University of Minnesota; filing date: July 28th 1992) an overview of CVD related processes that could be used for metallisation of substrates is given. A considerable amount of metal is deposited on outer surfaces of the substrates often smoothing out the porosity of the material to some extend. For thick substrate materials a temperature gradient through the substrate can in addition affect homogeneity of the deposition. In some cases a process of calcination by heating the catalyst in air to a few hundred °C is applied in order to improve catalyst activity.

Catalytic activity could be further improved by preparing finely divided metal and a variety of approaches was established for the preparation of metallic particles, which could be collected on a support material.

Several different approaches for the production of fine metal powders have been developed. It is known from the description of figure 6 of US 6 716 525 B1 (inventor: T. Yadav et al.; filing date: June 18th 2003) that the residence time of an in-situ formed metal fine powder can be engineered by selecting a feed location. The preferred energy source for the high temperature process is a plasma generator. A milling procedure can be applied to particles produced.

An approach taught by US 2 900 245 A (assignor: General Aniline & Film Corp.; filing date: January 24th 1957) comprises a closed loop process. With an inert gas thermal decomposition of a metal carbonyl may be controlled by controlling conditions of temperature, pressure and gas velocity. Metal particles in a dimension of 1 micron size and bigger can be produced. Additional information how a carbonyl decomposition process may be controlled by a vessel of which its free internal space is used as decomposition zone can be found in US 1 836 732 A (assignor: I. G. Farbenindustrie A. G.; filing date: March 4th 1930).

US 5 064 464 (inventor: Y. Sawada et al.; assignor: Mitsubishi Petrochemical Company Ltd.; filing date: Nov. 9th, 1989) claims production of ultrafine metal particles in a reactor with a process by which a high temperature diluent gas from a conduit is brought in contact with a mixed gas with the transition metal carbonyl compound from a nozzle outlet of a conduit. Heat of 300 °C to 800 °C for decomposition is instantaneously supplied from high temperature diluent gas. Possible clogging of conduits and nozzles by metal may occur when thermal decomposition of metal carbonyl is applied.

The process disclosed in RU 2 161 549 C1 (applicant: OAO INST GIPRONIKEL et al.; filing date: July 04th 2000) is preferably used for the production of Ni-nanoparticles with controlled size in the range 0.5 µm to 5 µm, where control is obtained mainly by means of temperature. This method uses thermal decomposition of Ni carbonyl diluted with the diluent gas carbon oxide from 10 up to 80 vol.-% with addition of oxygen by 0,01 to 0,1 vol.-%. Ni carbonyl and the diluent gas are fed with two separate feeders into the reactor. The flow rates of Ni carbonyl are larger than 83 l/min, while the flow rates of carbon oxide, pre-heated to temperatures between 20 and 220 °C is larger than 333 l/min. The internal temperature of the decomposer is between 240 °C and 280 °C, by means of the decomposer inner walls heated to a temperature up to 470 °C.

WO 2007/136 389 A2 (applicant: Directa Plus Patent & Technology Limited; priority date: August 10th 2005) proposes to employ a flow-reactor vessel which may be operated in a certain temperature range, pressure range and with controlled amount of added energy. Thus, the process of producing nano-scale metallic particles is basically controlled by the environmental conditions within the reactor. In a further embodiment, the reactants can be borne on a stream like a fluid stream, especially an inert gas stream which may pass through an injector into the reactor vessel. While WO 2007/136 389 A2 proposes to operate the reactor by feeding at least one metal carbonyl, a similar patent application by the publication number WO 2007/021 768 A2 (applicant: Directa Plus Patent & Technology Limited; priority date: August 10th 2005) refers to continuously feeding at least one decomposable moiety selected from a group of complexes or compounds.

Additional further details how to produce nano-scale particles may be derived from WO 2007/021 769 A2 (applicant: Directa Plus Patent & Technology Limited; priority date: August 10th 2005), WO 2007/021 770 A2 (applicant: Directa Plus Patent & Technology Limited; priority date: August 10th 2005), WO 2007/142 662 A2 (applicant: Directa Plus Patent & Technology Limited; priority date: August 10th 2005). More details of production facilities and of the method using a heating gas for moiety decomposition and metal nano-particle production are described in EP 2 425 915 A2 (applicant: Directa Plus SRL; filing date: September 1st 2010) and in EP 2 425 916 A2 (applicant: Directa Plus SRL; filing date: September 1st 2010).

The Patent US 5 641 723 A (assignor: Studiengesellschaft Kohle mbH; filing date: April 7th 1992) describes yet another method for the production of doped metal supported catalysts. The support material is exposed to a solution of the metal compound at a temperature between -18 °C and +25 °C. The method also involves an optional after-treatment of the sample. Several of the examples given in document US 5 641 723 A are referring to activated carbon catalysts, which are produced with metal clusters or aggregates formed in solution.

A similar method was used for metal zeolite catalysts, in particular nickel zeolite catalysts e. g. in C. Zhao and J. A. Lercher, Angew. Chem. Int. Ed. 51, p. 1 to p. 7, (2012). The method referred to was named incipient impregnation, where the solution of the active metal precursor is drawn into pores by capillary action. The catalyst is thought to be useful for production of biofuels.

A fluidized bed reactor for production of Pt nanoparticle catalyst using atomic layer deposition (ALD) was described by J. Li et al. in Applied Catalysis B: Environmental 97, p. 220 to p. 226, (2010). Platinum particles with an average particle size of no less than about 1.2 nm were produced on a mesoporous silica powder gel substrate and catalytic activity of the produced samples for CO oxidation could be verified. A very similar reactor was used before by D. M. King et al. as described in Surface & Coatings Technology 201, p. 9163 to p. 9171, (2007), for deposition of Al₂O₃ films on silica particles, TiO₂ particles, BN platelets, Fe particles, PMMA polymer particles and single wall carbon nanotube bundles (SWNT).

In the patent US 5 876 793 B (assignor: Ultramet; filing date: February 21st 1996), different versions of a turbulent fluidization flow bed reactor were considered for encapsulating coating of fine particulates with different metals. A heated upstream portion of the reactor was leading at the exit of this portion to downstream pipes for circulation.

An overview of selective catalytic reduction (SCR) of NOₓ gases with ammonia by Iron Zeolite catalyst is given in S. Brandenberger et al., Catalysis Reviews 50, p. 492 to p. 531, (2008). Catalysts for SCR are often required to have good catalytic activity at low temperatures and hydrothermal stability at high temperatures. It was found that the topology and the metal at the active sites, introduced e. g. by metal ion exchange processes in liquids can be important factors in this respect. At high temperatures processes like de-alumination of zeolite and loss of the introduced metal like iron can impede or suppress any catalyst activity. Further studies of Iron-zeolite properties, where the catalyst is produced with the ion exchange method in a liquid, are described e. g. in S. Brandenberger et al., Applied Catalysis B: Environmental 95, p. 348 to p. 357, (2010). The Journal of Catalysis 268, p. 297 to p. 306, (2009) is discussing the relevance of Zeolite Brønstedt acidity for binding metal ions in aqueous solutions. Spectroscopic data and calculation of statistical distributions of different Iron species in zeolites can be found in Applied Catalysis A: General 373, p. 168 to p. 175, (2010). Further approaches for catalyst optimization are discussed in Ind. Eng. Chem. Res. 50, p. 4308 to p. 4319, (2010) by the same research group.

M. S. Kumar et al. describe in the Journal of Catalysis 227, p. 384 to p. 397 (2004) an analysis of UV/Vis diffuse reflection spectra (DRS) of catalysts for distinguishing between different types of isolated Fe species as well as FeₓO_{y} aggregates of different size. Further details on this spectroscopic method can be found in J. Perez-Ramirez et al., Journal of Catalysis 223, p. 13 to p. 27 (2004) and in S. Bordiga et al., Journal of Catalysis 158, p. 486 to p. 501 (1996).

An iron impregnated zeolite catalyst for reduction of NOₓ with CO or C₃H₆ is described in Y. Okamoto et al., Studies in Surface Science and Catalysis 105 p. 2051 to p. 2058, (1997), but detailed understanding of the catalytic activity still requires further scientific research. A follow up article by Y. Okamoto et al. in the journal Physical Chemistry, Chemical Physics 4, p. 2852 to 2862, (2002) describes preparation of intrazeolite molybdenum oxide clusters and the catalysis of the oxidation of ethyl alcohol. Different production methods were tried for the catalysts, including a chemical vapour deposition process (CVD) using thermal oxidation of molybdenum carbonyl and an impregnation technique using an aqueous solution of a molybdenum oxide compound. It was concluded from experimental observations that the impregnation method may favour formation of monomeric Mo oxide more than the CVD method. Furthermore, it was concluded that additional heat treatment of the catalyst materials may lead to a transformation of Mo oxide dimers, some of which may form monomeric species.

Some residual solvent molecules or impurities of the solvents used may have unfavourable effects on catalyst activity or stability. There are some limits with such technologies e. g. for the control of locations, where the metal nano-particles can be deposited, in particular when access to the locations is spatially limited or when solvent molecules shield surface adsorption sites. Furthermore, nano-particles or thin metallic films deposited on a support or prepared from solution may not show the desired catalytic activity.

The patent US 6 489 258 B1 (assignor: Massachusetts Institute of Technology; filing date: October 15th 1999) describes a method for binding molecular compounds to specific surface sites of a zeolite, namely oxygen functionalities. These sites can be activated with initial process steps using silane and formation of covalent bonds to compounds, which are adsorbed on the substrate as precursor for metal or metal oxide catalyst. In this process compounds like palladium organic complex were used.

Studies from F. Seel et al. in Z. anorg. Chem. 534 p. 159 to p. 174, (1986), show that the physisorption of iron pentacarbonyl on zeolites leaves the pore structures intact. The energy required for desorption appears to be higher than the energy required for decomposition of physisorbed iron pentacarbonyl. Desorbed fragments, so called sub-carbonyls tend to migrate to the outer surface of zeolite particles and aggregate there in relatively large iron particles. Thermal desorption of Iron pentacarbonyl from specific Zeolites was also investigated by T. C. Golden et al. in Ind. Eng. Chem. Res., 30, p. 502 to p. 507, (1991), where efficient desorption due to heat treatment for regeneration of a filter was found.

The use of Iron pentacarbonyl catalysts for Fischer-Tropsch type catalysis is discussed by Th. Bein et al. in the Journal of Physical Chemistry 90, p. 4851 to p. 4856 (1986). The catalyst was prepared by crushing a zeolite into fine powder, adsorption of iron pentacarbonyl at room temperature followed by a degassing procedure. Afterwards the catalyst sample was exposed to oxygen at 77 K liquid air temperature in order to transform the iron pentacarbonyl. Experiments carried out by exposure to oxygen at room temperature gave similar results as discussed in Th. Bein et al., Ber. Bunsenges. Phys. Chem. 90, p. 395 to p. 398 (1986). When alumina or silica support materials were used, aggregation of iron particles occurred at lower temperature than using zeolite. An example for production method of low bulk density silica can be found in US 3 556 725 (inventor: V. Chiola et al.; filing date: February 26th 1969). Aspects elucidating the role of diffusion for the synthesis of C₅₊ molecules using cobalt as catalyst metal for Fischer-Tropsch type catalysis are described in the article by E. Iglesia et al. in Topics in Catalysis 2, p. 17 to 27, (1995). Since impregnation is carried out using solutions, control over contact time by means of filtration techniques is not very satisfying. Formation of CH₄ is considered as an unwanted by-product in this type of synthesis. In US 4 532 229 (inventor: R. A. Fiato et al.; filing date December 14th 1983), a process for preparing a Fischer-Tropsch mixed metal Fe-Co catalyst from metal carbonyl in a slurry liquid is suggested. The catalyst is used for alpha-olefin production from metal carbonyl by conversion of CO/H₂ into hydrocarbons in the size range C₂-C₄.

All cited prior art documents are incorporated by reference in this document, which means that the content of the cited documents may be considered to be incorporated by their subject matter. This is done with the objective to avoid re-defining generally known terms of the present invention newly although known by persons skilled in the art. The cited documents inter alia serve as basis for definitions used herein unless a different meaning is given by the present specification.

### Difficulties known from prior art and approach to the problems

There is a general demand by the chemical industry or by industries providing raw materials or fuels for simple production methods that can provide catalysts with good activity. Metal atoms have the tendency to migrate on surfaces of support materials and form aggregates, when the support is held at elevated temperatures, thus limiting the lifetime of catalysts. Since some technological obstacles may not be overcome too soon by tuning material properties, more emphasis is put on ease of manufacturing and cost efficiency for improvements of catalysts in industrial production. On the other hand, catalysis may depend on the concentration of the metal on the surface. Therefore, it is one objective of the present invention to improve control over catalyst material production. Another objective of the present invention is the formation of a high density of catalytically active sites and thus the production of efficient metal catalyst materials. Furthermore the production is supposed to be environmentally friendly or at least ecologically acceptable, e. g. in terms of energy consumption. It is also an objective of the invention to propose a reactor, in which catalysts can be efficiently and safely produced.

### Description of the invention

The difficulties known from prior art and further problems can be overcome at least to some extent by using the inventive production process according to claim 1 for producing solid catalyst material. Furthermore, some difficulties are rooted in aspects of an apparatus, in which solid catalyst material is produced, especially in accordance with claim 1. The inventive apparatus of claim 14 has been designed to overcome such problems. Catalyst material can be produced based on this invention, which may be useful in various reaction processes and applications.

Solid catalyst materials are primarily used for heterogeneous catalysis. Catalysed reactions can be gas-phase reactions or reactions in liquids, whereas the catalyst is solid. A basic material for the catalyst is a solid material. In a production process for producing the solid catalyst material, a solid material is activated for specific catalytic reactions by means of a number of process steps, like adding metal. Since catalyst activity depends on a surface area exposed to reactants, the solid material has preferably a rough surface. The solid material can be perforated. At least one pore or channel of the solid material is leading from an outer surface into an inner volume of the material. The pore is extended in one dimension at least a factor of 10 further than in a second dimension. Several of such pores or cavities, generally the pores or the cavities can also be named voids. Even larger surfaces can be achieved by using a sponge-like solid material. The solid material can have a multiwall structure, reminiscent of a cross-section of a Russian doll, with walls comprising cavities or pores. A structure comprising interspaces between walls facilitates penetration of the solid material by gas. A plurality of pores can traverse the solid material in at least one direction. The pores can have branches. At least one pore, preferably more than one pore, can have second orifices through which gases can enter or leave. Pores are often cylindric due to crystalline arrangements. There are also pores with circular, elliptic or other cross-sections, which can be useful. A gas can enter at least one pore or at least one cavity through at least one orifice and diffuse within the pore or cavity. Therefore, as an alternative, solid materials can be used in the production process, which has a surface that is enlarged by at least one cavity. The cavity is preferably located in the inner volume of the solid material and has an opening, through which gas from an outside atmosphere, a gas reservoir or a gas source can enter into the cavity. The cavity can be spherical, like a bubble or a group of bubbles. Solid materials having a network of interconnected cavities are particularly useful because the surface to volume ratio is larger compared to such ratio of solid material of the same mass that has no pores or cavities.

The pore or cavity is preferably formed in a production process of the solid material. Therefore, the pore or cavity can be due to a crystallisation process, a crystalline structure of the solid material, a foaming process or a templating process. Typical pores or cavities of solid materials used have one diameter of less than one micrometer. The total surface area can be even larger by using solid materials with pores or cavities of less than 50 nm (nanometre). Using pores or cavities of less than 2 nm provides an even greater surface area.

The solid material can be a mesoporous silica-based material. Natural silica-based materials that can be used as solid materials are known from frustules of diatoms or radiolarian. Typical outer diameters of such materials are 0.1 to 0.2 mm. Mesoporous materials have typical diameters of pores between 2 and 15 nm. Also macroporous materials having diameters greater than 15 nm can be used. Other types of solid materials useful for catalyst production with mesoporous structures can be based on alumina. Mesoporous materials can also comprise oxides of titanium (TiₓO_{y}), tantalum (TaₓO_{y}), niobium (NbₓO_{y}), tin (SnOy) or other metals. Amorphous silica can form the skeleton of the solid material having pores between 1.5 and 20 nm depending e. g. on the chain length of surfactants used for preparation of the silica.

Another group of materials that is often used for catalyst production are zeolites. Zeolite articles are made typically by microporous materials having pores of less than 3 nm diameter. The zeolites are often formed by elements like aluminium (Al), silicon (Si), phosphor (P) and oxygen (O), especially in controllable proportions giving a majority of elements of oxygen in comparison to elements of aluminium or silicon. Some zeolites bear additional elements like Ca (calcium), Sr (strontium) or barium (Ba). The elements like aluminium (Al), silicon (Si), phosphor (P) and oxygen (O) form a framework structure for pores, which is also named host. The host can be amorphous, having a short range order with respect to diffraction experiments, or crystalline. The framework structure can also be polymorph or basically crystalline but with a degree of stacking disorder. Often zeolites also contain crystalline water. Other components of zeolites are cations like sodium (Na⁺), potassium (K⁺), calcium (Ca²⁺) or Mg²⁺ (magnesium), which can be replaced by other cations since they are rather loosely bonded to the crystalline structure. Other types of zeolites that could be used for catalyst production can have crystalline structures with anionic core and cationic periphery. Other names for zeolites are aluminum silicates or molecular sieves. On the atomic scale, pores of the zeolite are cage structures, which can be categorized e. g. by periodic atomic ring structures of Si or Al atoms. The ring structures can typically not be penetrated by molecules larger than water (H₂O). In an advantageous production process the molar ratio of SiO₂ to AlO₂ of the used zeolite is around 37.4.

Another type of solid material that can also be used as a skeleton-type structural template of a solid material and that can be used for solid catalyst material production are metal foams (also called metallic foams). Metal foams have a cellular structure, where the walls are made of solid metal. The metal foam can be of any metal, even though foamed aluminium is frequently used. Closed cell foam has a particularly rough surface and a low weight. The available surface for catalysis is even larger, when open cell foams are used. Typically 75 % to 95 % of the volume consists of spaces that can be filled with gas. Open cell metal foams can be produced based on a skeleton material like polyurethane foam. The foams can have cavities of less than 2 mm in diameter. Cavities are preferably smaller than 0.1 mm in diameter. Metal foams can be mesoporous or macroporous materials, however, also microporous thin metallic films can be produced e. g. by electrochemical processes and be used in metal catalyst production

Instead of the before-named solid materials, similar effects may be achieved by using an activated carbon, a high surface area carbon material or material of graphene layers as starting material, especially for building the solid material. Solid material comprised by only a small number of graphene layers is very attractive. A small number, by other words, few graphene layers are present, if less than 10 layers, more preferably, less than 5 layers are counted (for a suitable production method, please refer to the teaching of EP 2 038 209 B1, which is incorporated herein).

For catalyst production, in other words the production of solid catalyst material, the solid material is exposed to a pre-cursor molecule, more precisely, per-cursor molecules, for introducing a metal into the structures or onto the surfaces of the solid material.

A metal complex for a production of nano-particles of metal can be a moiety like organometallic compounds, metal coordination compounds or anorganic metal bearing molecular educts. Preferably, metal carbonyls are used but other metal containing molecules and mixtures thereof can be supplied into a fluidized bed reactor through a feeder. Catalyst metal produced in the fluidized bed reactor is selectively produced from metal complex containing at least one of the following chemical elements:
niobium (Nb), tantalum (Ta), titanium (Ti), vanadium (V), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au). This list of usable chemical elements is not meant to exclude other metals like Lanthanides or Actinoides or other metals of the periodic table and combinations thereof not mentioned explicitly by name for production of metal nano-particles.

The metal is activated by stripping off other constituents of metal complex or metal-organic compounds. A solid material can adsorb a metal complex. The metal complex is transformed into a catalytically active surface site by an exothermic chemical reaction using a gaseous promoter of the reaction. The metal set free by fragmentation or decomposition, in particular of a metal carbonyl, binds to the solid materials. The metal can aggregate in nano-particles while decomposition of the metal complex occurs.

One advantage of the process and the apparatus of this invention is the capacity to produce metal or metal oxide that is dispersed on a solid surface on an atomic size scale.

The metal is preferably adsorbed and bond to a structure of the solid material, which is concave in at least one direction, like a potential well, or a shell. The complex or compound providing the metal is selected to fit into the pore or cavity of the solid material. The metal complex or the organic compound is stable under conditions used for adsorption to the solid material.

The temperature of the batch of solid material can be controlled during impregnation. Over all, the temperature is kept in a room temperature range between 15 °C and 25 °C. The overall temperature, meaning the average temperature over time and space during impregnation, namely during adsorption step and/or decomposition, can also be kept below 20°C room temperature, especially in order to improve adsorption.

The metal complex or metal organic compound can be vaporized. During exposure to the solid material, the metal complex or the metal organic compound enters the pore or cavity of the solid material. An adsorption of metal complex inside the structure of the solid material is one aspect of an impregnation of the solid material with the metal. Another name for this process is infusion. However, the process of this invention is a gas-phase or vapour-phase process and therefore clearly distinguished from a liquid-phase process. In the production process, the metal complex is adsorbed on the surface of the solid material. Adsorption is particularly efficient in the pore or the cavity of the solid material, since after entering these structures, the metal complex can have a plurality of subsequent interactions with the surface. The metal complex is trapped inside the structure and unable to escape in at least two spatial directions. The adsorption to the surface can be chemisorption or physisorption depending on the strength of attractive interaction that is established between the metal complex and the solid material.

It is yet another advantage of the present invention, that adsorption of the metal complex can be carried out for a controllable depth or length of the pore or cavity.

Another step of the catalyst production method is a decomposition of the adsorbed metal complex. The metal complex is activated by interaction with a means of oxidation like an oxidizing gas. The interaction is preferably exothermic leading to at least partial liberation of the metal provided with the metal complex. The metal complex is oxidized by the oxidizing gas. Where the metal complex is oxidized, at least one ligand of the metal complex can be replaced by oxidizing gas. The oxidizing gas can be air, especially because of availability. Also pure oxygen can be used as oxidizing gas. Other oxidizing gases can be halogen or ammonia, depending on the metal complex, the exothermicity of the oxidation reaction and the type of catalyst to be produced. In some cases it is advantageous when the oxidizing gas is diluted by a first carrier gas. A first carrier gas can be mixed with an oxidizing gas, having e. g. a partial pressure of less than 10 %, preferably less than 1 % of oxidizing gas in a carrier gas pressure. The carrier gas can also enter the pore or the cavity of the solid substrate. The carrier gas may in some cases provide activation energy to bring about or to facilitate reaction between oxidizing gas and metal complex.

After oxidation of the metal complex, the metal can bind to a surface, preferably an inner surface of the solid material. Since a diameter of the metal complex and a diameter of the carrier gas are smaller than the opening of the pore or cavity of the solid material, the first metal complex entering the pore or cavity is not blocking the entrance for additional metal complex. Decomposition products, like carbondioxide, can escape. A plurality of metal complex or metal organic compound molecules or particles can enter a pore or a cavity. A first metal atom can be bond to a first site in the pore and a second atom can be bond to a second site in the pore. The first site and the second site are located along the pore. At least a part of the surface, which confines the pore or the cavity, will be covered with metal. The metal can form a chemical bond, which prevents the metal from being released off the surface under room temperature or at the adsorption temperature. The metal remains on the surface, preferably attached to an adsorption site, especially at temperatures below 400 °C. Some of the structures of the solid material can be energetically preferred sites for binding metal. At least some of the surface structures bind metal, when the method for producing the catalyst is applied. These structures are delimiting the pore or the cavity. Since a plurality of surface structures is available, metal can be bound at a plurality of sites, preferably single adsorption sites for a metal complex, thus being dispersed. A surface site or surface structure can be a lattice configuration of a zeolite. Typically a monomeric species of metal, meaning a metal atom or a metal oxide molecule is bonded with the surface. One surface structure can also bind two species of metal atoms or metal oxide forming a dimeric species of metal. The metal is often bond to the oxidizing gas; however some metals may also bind to the surface of the solid material as atoms. The monomeric species or dimeric species bonded to the surface site can also aggregate into oligomers or even larger clusters, which are named nano-particles of metal, e. g. by binding additional metal complexes and oxidation, especially by interaction with oxygen. However, since oxidation is often exothermic, there is a good probability that the energy released by oxidation of a metal complex will overcome desorption energy of second metal complex molecules to the site. The number of metal atoms at one specific site of the surface can scale down automatically and thus dispersion of metal is improved. The metal or metal oxide bonded to the solid surface is preferably forming a bi-functionalized catalyst surface. The metal bonded to the surface can also be used as precursor for formation of catalytically active structures, which can be activated in a subsequent process step by chemical reaction like reduction or oxidation.

Good control of catalytic activity of a catalyst can be obtained by controlling the number of active sites of the catalyst. By one aspect, the number of active sites can be adjusted with weight-percentage of metal deposited on solid material. The active sites are sites, which can be exposed to one or several reactants and which enhance the chosen chemical reaction. The catalyst can be particularly efficient with a plurality of monomeric species forming catalytically active sites compared to nano-particles of metal or nano-particles of metal oxide. All monomeric species, in particular single atomic, ionic or respective oxide species, e. g. having a first or a second type of coordination, exceed all oligomeric species by number. Oligomeric species can be cluster, comprising metal or metal oxide. Oligomeric species can have a size and in particular a mass distribution due to variation of number of atoms bonded together. Oligomeric species can also be nano-particles, when they are larger than 1 nm (nanometre) in at least one dimension. By estimation or counting numbers of monomeric species and numbers of oligomeric species can be determined. The number (more precisely, the numbers) refers to species attributed to monomeric or oligomeric species, which can be found within a specified surface area unit of the solid catalyst material. Of course, statistical significance of the method to determine such numbers needs to be ascertained. The content of monomeric species and oligomeric species can be analysed with UV-vis optical spectroscopy, in particular by using the diffuse reflectance method. The sub-bands attributed to monomeric species in the UV-vis spectra are often located at shorter wavelengths than the sub-bands attributed to oligomeric species, cluster or nano-particles. Preferably at least 50 %, more preferable at least 60 % of the measured species are monomeric. The number of species is proportional to the strength or also the intensity of the sub-bands measured in the UV-vis spectra, preferably using the method of diffuse reflectance spectroscopy. Also other spectroscopic methods or microscopic methods like scanning probe techniques can be applied for measurement of numbers of monomeric species and numbers oligomeric species on a solid catalyst material for comparison.

The bi-functional catalyst comprises a Lewis acid, namely an electron pair acceptor and a Lewis base that is a donor of a pair of electrons. The Lewis base is capable of forming a Lewis adduct together with an added Lewis acid. Lewis bases are particularly useful to modify the activity and selectivity of metal, especially transition metal, catalysts.

The solid catalyst material is produced in an apparatus comprising a fluidized bed reactor. A special design of this reactor has been developed for production of solid catalyst materials comprising metal from volatile moieties, like metal complex. The apparatus is particularly useful for producing catalyst materials with a large surface. The surface area is in particular larger than the surface area of a geometric body of the same size, at least by a factor of 1.5, due to pores or cavities in the solid material. The content of catalyst metal in a solid catalyst material can be improved by increasing the dispersion of the metal throughout the material.

One component of the apparatus is a fluidized bed reactor for solid particles.

The fluidized bed reactor comprises a reactor vessel. A fluid can be passed through the reactor vessel so that the solid material in the reactor vessel is exposed to the fluid. The fluid can be a liquid. In some instances, it is appropriate to use a hydrophilic liquid. In case, some kind of impregnation is desired a hydrophobic liquid is the liquid of choice. Preferably, the fluid is a gaseous material. In those circumstances, the fluidized bed reactor can also be named a gas bed reactor. The fluid may comprise a gas and droplets of a liquid or a vapour. In a fluidized bed, a solid particle or object is at least partially carried by a flow of a fluid against a force like gravity. Fluidization is used in order to improve exposure of the particles to the fluid. The dynamical behaviour of the particles within the reactor vessel is rather complex and still not completely understood. Particle movements by the flow of the fluid depend largely on the specific type of particles and properties like mass, density or shape. Fluidization can also be achieved or at least improved by applying centrifugal, electric or magnetic forces to the solid material.

Advantageously, the solid particles are fed into the reactor vessel through a solid particle feeder. The solid particles can also be deposited into the reactor vessel through a port or a filler opening, which is preferably closable by a flange or a lid in order to retain the particles or the gas in the fluidized bed reactor. The flange or the lid may comprise openings allowing a gas flow into or out of the reactor. The flange can also be a gas distributor for directing the gas flow into the reactor vessel. The apparatus comprises at least one gas feeding filter. A first gas feeding filter is located on one end of the reactor vessel. The gas feeding filter limits a first end of the reactor vessel by providing a border between an inner volume of the reactor vessel and an outer volume. The outer volume may be connected to a gas distribution system, like a mixing stage, by a conduit. Only one side of the gas feeding filter, the side facing the inner volume of the reactor, is exposed to solid material or solid catalyst particles. A gas feeding filter is retaining the solid particles in the reactor vessel. Gas can penetrate the gas feeding filter from a first side, which is connected to a gas source, to a second side, which can support the solid particles. The apparatus can comprise a second gas feeding filter, which can be used for feeding a second gas into the reactor vessel. For producing well kept solid catalyst material, the gas comprises a metal complex and preferably an inert gas, which is also named carrier gas. The metal complex is to remain in the reactor vessel at least in part. The carrier gas is to leave the reactor vessel through a second end of the reactor vessel. The second end of the reactor vessel is located at a distance from the first end of the reactor vessel in the direction of a gas flow through the reactor vessel. The reactor vessel is a flow through reactor. The second end is limited by a gas exit filter. The first side of the gas exit filter can be exposed to solid particles. Gas leaving through the gas exit filter from the reactor vessel can fill a space, like a conduit, on the second side of the gas exit filter.

At least one of the filters, a gas feeding filter or a gas exit filter is perforated with pores. The pores stretch from a first side of the gas filter to a second side of the gas filter, thus allowing a flow of gas through the filter. The cross-section of the pores preferably maintains a flow of a carrier gas and a flow of metal complex. The pores in the filters, however, cannot maintain a flow of solid particles. At least one diameter of the pore is smaller than at least one diameter of the solid particle. Preferably, the area of a cross-section of the pore is smaller than a cross-section of the solid particle in order to prevent solid particles from getting stuck in an opening of a pore.

The apparatus further comprises at least one gas mixing stage. A very suitable place to locate the gas mixing stage is outside the reactor vessel. The gas mixing stage is preferably located at a distance from the gas entrance filter. The gas mixing stage can dilute a first gas with a first partial pressure by a second gas with a second partial pressure. A gas mixing stage can also be used to accommodate vapour in a carrier gas. The gas mixing stage is operatively connected to at least one gas feeding filter. A gas mixture can be provided to the gas feeding filter from a gas mixing stage through a conduit or a tube and enter the reactor vessel. The controlled mixture of gas is fed into the fluidized bed reactor. The components of the gas are controlled in the gas mixing stage. The gas mixing stage can provide controlled mixture of a carrier gas with a metal complex. The gas mixing stage can also provide a controlled mixture of a metal complex. Furthermore, a gas mixing stage can provide a mixture of a carrier gas with another gas like an oxidizing gas. The carrier gas is typically an inert gas like a noble gas, nitrogen or carbon dioxid. A gas source for carrier gas is e. g. a gas cylinder with a regulator or a gas circulation system. Also oxidizing gas is provided from a gas source. The oxidizing gas can comprise air. Dried air can be used, when a reaction path of metal complex with water is to be avoided. The oxidizing gas can comprise a first oxidizing gas and a second oxidizing gas like mixtures of halogen and oxygen. The gas mixture and/or the vapour mixture in carrier gas can enter the fluidized bed reactor by being fed into the reactor vessel through a feeder.

Another auxiliary unit of the apparatus is a cooler connected with a reactive vessel. With the help of the cooler, the temperature from exothermic reactions going on inside the reactor vessel can be limited.

Further advantages and benefits of the invention can be derived from the following explanations which may bare additional inventive ideas by themselves.

Especially useful for the production of solid catalyst material are solid particles that are metallic materials or materials with semi-conductor properties. Solid particles can be materials which isolate electric current or materials which support electric current. There are non-metallic materials that may be used for forming the solid particles, additionally or alternatively to the metallic materials or the materials with semiconductor properties. In typical applications of the apparatus, the geometric form of the particles is maintained. The particles can be spherical or elongated particles with a cigar shape. The particles can be pellets or beads. They may also have a shell structure or thin walls. The particles can also resemble or be derived from basic geometric configurations like cylinder, cone, pyramid, cube, prism, torus, polyedric body, knot-type or entangled body or similarly shaped structures. Also a cavity can have such a shape. One preferred structure used is a geometric body derived from a hollow cylindric structure. The cross-section of the hollow structure can be elliptic, parabolic or hyperbolic, providing a volume that is accessible by gas. Another preferred structure is a particle having one of the described geometric outer forms or a form that is derived from an accumulation of such structures having interstices or interspaces, which are accessible by gas or vapour due to interconnections by gaps or channels between the solid components. Such an object can have a dimension of more than 1 mm or more than 10 cm. The objects are preferably formed before being fed into the reactor.

The pores of the solid material can be aligned throughout the volume of the solid material. Cavities can be ordered, like in a chain, from one side of a solid material to a second side of the solid material. However, disordered meso-structures may be preferred in some applications, in particular when ordered structures cannot be obtained, or come with other disadvantages. Also disordered structures can provide good catalytic activity. Ordered pores or cavities may provide larger surface area, especially when pores or cavities with a first diameter are combined with pores or cavities of a second diameter e. g. in a lattice-like configuration. A high density of pores, alternatively or additionally a high density of cavities in a solid material corresponds to a large surface area and to a low unit weight. The floating behaviour of a solid material can also be improved by having a large internal surface area.

An additional benefit from using such microporous solid materials is the use as a molecular sieve since molecules, which are e. g. larger than 2 nm, cannot enter pores or cavities of the solid material thus being separated from a flow of gas into the pores. Particularly good properties in respect of solid catalyst production can be achieved with materials like Zeolites having pores of less than 0.7 nm diameter. Good filter properties for particles and good transmission of gases are combined in such solid materials. The pores or cavities are preferably larger than 0.2 nm so that gaseous molecular substances, like H₂, CO, NOₓ, metal carbonyl or metal complex, can enter the solid material.

The surface area of mesoporous materials can be further increased by depositing a layer of microporous materials like zeolites on the mesoporous structures. At least some of the pores can be closed on one end.

Metal-organic compounds of at least one aforementioned metal atom with at least one NH₃ (ammine) or at least one H₂O (aqua) or at least one CO (carbonyl) or at least one NO (nitrosyl) or at least one H₂S (hydrogen sulfide) are used in different preferred production processes of solid catalyst material. The metal can be provided in a metal complex, like metal carbonyl molecules. The metal can also be provided by metal organic compounds like metal bond to aromatic or aliphatic hydrocarbons. The process is particularly suited for volatile moieties being fed into a reactor vessel. Some metal-organic compounds previously described can be fed into the reactor vessel in preferred applications for the production of compound metal nano-particles. Such compound nano-particles contain a number of constituents bonded together in a matrix of metal.

The metal complex or metal organic compound can be vaporized for being mixed or diluted with a carrier gas, preferably without chemical reactions that are setting free the metal.

The concept of this process and of the apparatus can also be applied for the production of small particles preferably with nanometre-scale dimensions, which contain metal. The production is carried out on the surface of a solid material. Particles in general can be understood as nano-particles with an average diameter on the scale of 1 nanometre (nm) to 1000 nm. Occasionally nano-particles are defined in the scientific community as particles with less than 100 nm diameter. In some preferred applications, the scale for nano-particles rather relates to sub-nanometre dimensions in the range from typical atomic dimensions to a diameter of 0.7 nm. Such particles can also be named cluster or islands on a surface, having specific size dependent magnetic, electronic and catalytic properties e.g. due to a strong surface curvature or the density or package of atomic or molecular components. For reasons of catalytic activity nano-particle diameters can be required in the range of 0.5 nm to 5 nm, preferably in the range 2.5 nm to 25 nm. Such particles could be 5 nm particles of nickel. The particles can comprise metal that is at least partially oxidized.

Another advantage of the present invention is a narrow size distribution of metal like nanoparticles of iron in the range of less than 0.5 nm, comprising at least 50 % of the particles produced. Also when different metals or different materials are combined, control of the dispersion of the metal is possible. A narrow size distribution can be produced below 10 nm. Such metal containing deposits can be smaller than 0.2 nm and comprise e. g less than 100 atoms. Particles having a large load of metal can be separated from particles having just a small load of metal, e.g. less than 1 % of their load. Such distributions can be separated into at least one narrow size distribution of less than one hundred nanometre width, more preferably less than thirty nanometre width, most preferably less than ten nanometre width for example by using separator means like a cyclonic separator or a filter connected to the reactor. Further aspects of catalyst particle production are the crystallinity, the geometry, the surface structure or the surface roughness of solid catalyst material particles with nanometre-scale dimensions. The solid material used can have micrometre-scale dimensions, like particles of less than 1 mm diameter. Also solid material having a diameter of more than 1 mm can be used, especially when the solid material is a component, in particular a preformed element, of a machine or a reactor.

By one aspect of adsorption control, a first section or a first length of a pore or cavity, like a section adjacent to an enveloping or outer surface of a solid material is exposed to metal complex, and a second section, namely an inner section of this pore or cavity that is located at a distance of the enveloping or outer surface of the solid material can be not exposed to metal complex. Adsorption of metal complex can only take place where the solid material is exposed to metal complex so that surface contact of metal complex can be established. The length of the first section, which can also be named the catalytically active section, can be less than 1 mm, more preferable less than 0.1 mm, or even less than 50 µm. This control can be carried out by a selection of parameters used for impregnation of solid material with metal complex, e. g. by limitation of exposure time and temperature of the solid material. A catalyst produced by means of this control has an activity area with a three dimensional distribution, which is limited in at least one direction, like a radial direction or a normal direction, especially in respect to an enveloping surface, within the solid material. Such a catalyst material is limited in a second direction by the enveloping surface of the solid material. The enveloping surface is a surface that is closely following the macroscopic shape of the solid material or particle, like a shrink wrap membrane, a skin or an eggshell, without entering into pores or cavities. The catalyst can support reactions where concentration of at least a first reactant, like CO, and a second reactant, like H₂, is sufficient by diffusion inside the pore or cavity. Synthesis of unwanted molecular species, by an educt concentration gradient along the pore or cavity is suppressed within the chemical reaction equilibrium. This process can e. g. lead to carbon chain termination with excess hydrogen and thus to an unwanted production of short hydrocarbons, like CH₄, when liquid hydrocarbons are demanded.

The adsorption of metal complex on a solid material for formation of a solid catalyst material can be controlled. Different parameters can be adjusted or monitored in order to improve the adsorption condition. A first parameter and a second parameter can be controlled simultaneously so that a good load of metal complex is adsorbed on the solid substrate surface. Adsorption is preferably achieved on inner surfaces of the solid material. Inner surfaces are surfaces which are at least partially enclosed by bulk matter of solid material. The ratio between inner surface and outer surface is preferably greater than 1. The outer surface is the surface that can at least partially be in contact with a second particle of solid material. One parameter that can be adjusted for control of adsorption is a concentration of a metal complex. The concentration is usually given as a partial pressure in a carrier gas. The concentration can also be adjusted by means of a vapourisation temperature or vapour pressure of the metal complex. Furthermore, a second metal complex can be mixed with the first metal complex. A second metal complex can be provided into a reactor simultaneously with the first metal complex, each metal complex with a predefined partial pressure. The ratio between the first metal complex and the second metal complex concentration can be adjusted. The second metal complex can also be provided with a second carrier gas. The first metal complex and the second metal complex can be mixed before entering the reactor vessel. The first metal complex and the second metal complex can also be mixed inside the reactor vessel, e. g. by sequential adsorption, first of the first metal complex and afterwards the second metal complex in the pores or cavities of the solid material. By controlling the concentration of the metal complex, interaction between different metal complexes or interaction between different molecules of a metal complex can be minimized. Adsorption in pores and cavities is improved and possible formation of aggregates of metal complex is impeded.

Adsorption can also be controlled by means of a gas flow preferably into a mixing stage, more preferably into a reactor vessel. Another method to provide metal complex is a flow of vapour, which can be controlled. The flow of gas or vapour can be adjusted by means of a valve or an orifice. The flow can also be adjusted by a source pressure for gas or vapour. The gas pressure inside the reactor vessel affects the rate of collisions of gas or vapour particles with solid material. Therefore, gas pressure can be increased in order to speed up adsorption. However, gas pressure may also adversely affect flow conditions of gas. Flow conditions for gas entering into pores or cavities of solid material or solid catalyst material can define an upper limit for gas pressure. Impeding the flow of gas or vapour through the solid material at high pressures, or blocking the access to the inner surfaces is preferably prevented. Vapour molecules of metal complex are typically larger than gas molecules or atoms and therefore particularly suited for control of flow conditions.

Furthermore, the temperature of a gas and/or a gas/vapour mixture can be controlled. By decreasing the temperature, the kinetic energy of particles, molecules or atoms impinging on solid material is reduced, thus increasing the sticking probability. Also the probability that molecules of metal complex are removed from the surface by momentum transfer from gas is reduced, e. g. by thermal equilibration between a carrier gas and a temperature controlled solid material. Controlling the temperature of the solid material may also improve adsorption of metal complex in pores or cavities. The temperature can be adjusted e. g. by heating the fluidized bed reactor. The temperature can also be adjusted by cooling the fluidized bed reactor. Heat from solid material inside the reactor vessel is transferred to the walls of the reactor vessel in a cooling process. Heat transfer can be radiative, conductive or both, especially prior to fluidization of the solid material. When the solid material is heated to a temperature, which is related to the vapourisation temperature of a liquid complex or the vapourisation temperature of a solid metal complex, adsorption on outer surfaces of solid material is reduced because the sticking probability of molecules to the surface is lowered. Therefore, molecules are less likely adsorbed on outer surfaces than on inner surfaces. Pores are less likely to be blocked on the outside so that adsorption on inner surfaces by metal complex diffusing into the pores is increased. The adsorption process can be stopped, when the vapour flow is interrupted. The flow of carrier gas may still continue in order to remove metal complex that is not adsorbed on or in solid substrates and still mobile for aggregation. The duration of the vapour flow starting from initialization of the flow of vapour and the flow of gas to the moment of interruption of the vapour flow can at least partially determine the amount of adsorbed metal complex. The adsorption enthalpy in small pores, like pores of less than 0.6 nm is higher than the adsorption enthalpy in larger pores, like pores of more than 5 nm. The adsorption enthalpy favours impregnation of small pores. When temperature of solid material or metal complex is reduced, e g. to room temperature or below, diffusion slows down. A reduced temperature shifts the adsorption equilibrium from a probability for desorption of a molecule to a probability for adsorption of a molecule on a surface. On the other hand, a higher temperature of a solid material or a metal complex, like a temperature of more than 40 °C, increases the diffusion rate and supports desorption of the metal complex from a surface. Less metal complex is deposited at the entrance of a pore or cavity. Metal complex penetrates deeper along the pore or cavity. Applying a temperature gradient starting with a higher temperature, like 40°C or even more, can be useful to counterbalance the two processes of diffusion and adsorption. Good control over the distribution of metal complex can be obtained throughout pores or cavities of solid material.

Another step of the production process is a decomposition of metal complex by oxidation. The process can be improved by controlling at least one parameter though preferably a combination of parameters is controlled for a good turnover of the oxidation reaction. One parameter that affects aspects of metal complex decomposition is metal complex concentration in the solid material. Metal complex concentration can be adjusted by adsorption parameters. Furthermore, a concentration of oxidizing gas effects the reactive decomposition of metal complex. The concentration of oxidizing gas can be controlled e. g. by mixing a partial pressure of oxidizing gas with a partial pressure of inert gas. Preferably, less than 1 % of the gas used for decomposition is oxidizing gas. Development of heat by exothermic oxidation can be reduced even further using less than 0.1 vol.-% of oxidizing gas mixed with inert gas thus forming 100 vol.-% decomposition gas. The oxidizing gas can comprise a first oxidizing gas and a second oxidizing gas thus forming a composition of gas, where the metal complex can be oxidized on one ligand by a first oxidizing gas and oxidized on a second ligand by a second oxidizing gas. In this way, temperature released by the exothermic oxidation process can be better controlled. The rate of oxidation, another factor for generation of heat, can also be controlled with oxidizing gas flow. When the oxidizing gas flow is increased, the oxidation will proceed faster than with a lower gas flow, provided that there is still metal complex for oxidation. The oxidation rate can be diminished by diluting the oxidizing gas in a carrier gas. When the partial pressure of oxidizing gas in the carrier gas is lowered, less oxidizing gas is available for reaction with metal complex. Therefore, reaction may take more time and less heat is produced within a period of time.

Oxidation can also be controlled by adjusting a temperature. The oxidizing gas can be pre-heated before entering the reactor vessel. Heat can speed-up diffusion of oxidizing gas into pores or cavities. Oxidation can be controlled by regulating the solid catalyst material temperature before oxidation and/or during the oxidation step. When the solid catalyst material is cooled to a lower temperature, heat produced by oxidation can be dissipated better. Heat from the oxidation reaction is preferably not transformed into desorption of metal complex and diffusion of metal complex out of pores and cavities. Cooling the solid material can maintain metal complex below decomposition temperature. The reaction path of oxidation for decomposition of metal complex is controlled and no other metal compounds are formed. The temperature of the solid material should remain at least in 90 % of the mass of the solid material below decomposition temperature of the metal complex. Furthermore, a duration of the oxidizing gas flow can limit oxidation reaction. By measuring gaseous oxidation products, a degree of transformation of metal complex can be followed and oxidation can be terminated by stopping the gas flow after a predetermined period of time. Oxidizing gas flow can also be terminated after a predetermined amount of reaction gas is produced. After termination the flow of a first oxidizing gas, a second oxidizing gas flow can be fed into the reactor vessel. A second oxidizing gas flow can be used for an additional functionalization of the metal introduced with an adsorbed metal complex. Also, an additional functionalization of the solid catalyst material can be made using a second oxidizing gas.

The metal complex provided into the reactor or fed into the reactor can be a metal carbonyl. The complex can comprise a transition metal like iron. Iron (Fe), nickel (Ni), cobalt (Co), copper (Cu), zinc (Zn) can be transition metals or first transition metals provided with a metal complex. The metal complex can also comprise a second metal of the same element or of a different element. A metal complex used for metallization of a solid material surface can be a metal like a precious metal, in particular platinum (Pt) or palladium (Pd).

An impregnation of the solid material with metal complex that is decomposed by oxidation is carried out for a specified quantity of solid material. The specified quantity can be less than 1 kg, when rare catalysts, in particular catalysts with rare metals are produced. The specified quantity is also named a batch of solid material. A batch of solid material can be less than 100 kg, in particular when catalysts for the production of basic materials like solvents, oil or plastics are produced. The solid material used has preferably gas conveying pores and/or cavities. A least a plurality of pores or cavities can guide gas through a volume element of the solid material. Gas can enter the solid material on a first side and leave the solid material on a second side. The impregnation or any other chemical processing step e. g. for pretreatment of the solid material or for after-treatment of the solid catalyst material is performed preferably on structures of solid material. Such structures are especially along the pores or cavities. Structures in the surface of the pores, cavities and the solid material can be modified by attachment of metal. Desorption processes can largely be suppressed by keeping the overall temperature below 0 °C. More preferably, the temperature is kept overall below -20 °C, which may already slow down oxidation of metal complex and therefore be useful for control of heat generation. When the temperature is kept below -60 °C, the diffusion of metal complex on the solid material surface can be suppressed almost completely. By another aspect, the overall temperature can be kept above condensation temperature. Preferably, the metal complex is used under conditions above the condensation point maintaining the metal complex in gas phase. Under such conditions, gas phase diffusion is efficient, so that pores or cavities of the solid materials can be penetrated and adsorption of metal complex on solid material can occur.

In a production process like a batch production process or a continuous production process metal complex is fed in a continuous flow using e. g. the carrier gas argon. The flow of gas and especially the flow of gas comprising a metal complex is entering the reactor vessel continuously at least for a pre-defined period of time, like a time of less than 1 hour. In continuous production, the time interval is preferably longer than 8 hours. The flow is preferably steady, so that no interruptions occur. The quantity of metal complex fed into a fluidized bed reactor can be 100 mg (milligram) per minute and per gram solid material. The flow of carrier gas can also continuously flush 30 mg metal complex per minute and per gram solid material into the reactor vessel. The solid material as basis for reference is measured or determined within the reactor vessel. When a low concentration of metal is required, the metal complex steadily fed into the reactor can be less than 30 mg per minute and per gram solid material. In particular when the catalyst metal is used as a promoter of the catalyst, 10 mg per minute and per gram solid material can be sufficient. The catalyst is e. g. a transition metal doped zeolite or a zeolite having a deposit of a catalyst metal on molecular sieve structures or on structures formed by introducing a vapour into inter-crystalline spaces of the solid material. It is also possible to up-scale the production process to quantities of more than 100 mg per minute and per gram solid material in the case of mass production of solid catalyst material, especially in a continuous production process.

Within the fluidized bed reactor, the solid material is exposed to a flow of gas or vapour from at least one direction. Therefore a second direction can exist that is shadowed from the flow of metal complex. Particles in the shadow of the flow of the metal complex are not exposed to metal complex. Therefore, adsorption of metal complex can be inhomogeneous, alternatively, adsorption is at least slowed down significantly. This is specially the case, when solid material is used with a single particle size of more than 1 mm. When solid material with a particle size of less than 1 mm is used, some of the pores or cavities of a solid material particle can be blocked by a second solid material particle. In this case, exposure of internal surfaces or inter-crystalline spaces to metal complex is hindered and adsorption is impeded. When the solid material is moved, the geometric configuration and interdistance between two particles of the solid material changes. Also the orientation of the solid material with respect to the flow of metal complex direction is changed. Therefore, parts of solid material which have been in the shadow of the flow of metal complex can be exposed to metal complex. By these means, adsorption quantity on the surface of solid material is increased.

The solid material often consists of particles, which are prepared before the production process is carried out. No cleaving of activated particles after impregnation with metal is necessary. The solid material can also comprise at least one particle. In such a case, the solid material can be a component of a reactor, which is ready for installation after impregnation with metal. The diameter of at least 1 of the particles can be less than 50 µm in at least a first direction, so that particles can be better handled with transport facilities or filling facilities like a feeder for powder. The particle can have a diameter of less than 1 µm in at least one direction. The particle can be atomically flat in a second direction or comprise of multiple layers in the second direction. Particles which are smaller in the first direction than in the second direction can be easily turned over in a flow of metal complex or oxidizing gas. Particles which have a structure of a flake or a nano-flake can easily flow within a fluidized bed reactor. Such particles are particularly well suited for impregnation under a weak gas flow of less than 1 ccm (cubic-centimetre) of vapour per minute and per gram of a thin layer of solid material.

The solid material can be fixed to a support in a pre-processing step. At least one particle of the solid material can be immobilized on the surface of the support. The solid material can also form a film on the support, like a zeolite film that is deposited on the support in liquid phase prior to the production of the solid catalyst material. The support can be a sieve structure or a pipe e. g. for gaseous or liquid reactants. The support can also be a honeycomb structure like a catalyst structure mounted in the exhaust for fumes from a combustion engine or a plant reactor. Also, natural substrates like cordierit can be used as a support. Other materials which can provide a large surface area for catalyst production are metallic foams, in particular metallic foams covered by a film of zeolite material, thus providing cavities and micropores in one sample.

The adsorption of metal complex can be further improved, when the solid material is prepared with an activation step prior to impregnation of the solid material. Before impregnation, the process step for solid catalyst material production can activate the surface of the solid material. The activation can be carried out by drawing vacuum on the solid material, especially on a vessel containing the solid material. Activation can be further improved by heating the solid material thus accelerating the evaporation of crystalline water or surface adsorbed water from the solid material. The solid material can be heated to a temperature of 80 °C to improve evaporation of water. When the solid material is heated to a temperature above 100 °C, also impurities with low vapour pressure, like solvents, can be removed and adsorption of metal complex in the activated solid material is further improved.

One way to impregnate solid material continuously is by providing a continuous input and output of solid material, especially solid material in the form of particles. The particles are impregnated continuously with metal from a metal complex. The ratio of the flow of solid material and the flow of metal complex is adjustable. By controlling adsorption and desorption of metal complex the density of metal in the solid catalyst material can be controlled. Also the ratio of the flow of oxidizing gas and the flow of solid material can be adjusted. The generation of heat that could affect the impregnation process e.g. by desorption of metal complex, can be limited. Heat generation is preferably kept below the temperature for activation of surface diffusion of metal complex or of metal on solid catalyst material. The flow of metal complex, the flow of oxidizing gas and the flow of solid material can be controlled independently from each other for optimization of production efficiency.

Even more sophisticated catalyst materials can be produced by combining the first metal and the second metal, especially transition metals, on a solid catalyst material surface. The first and the second metal can form a single particle like an alloy. The first and second metal can also be bounded to different sites of the solid surface. This technique of bounding to different sites leads to forming a multifunctional solid catalyst material. The first metal is introduced in pores or cavities of the solid catalyst material by carrying out a first impregnation cycle. The second metal can be introduced by carrying out a second impregnation cycle. An impregnation cycle comprises steps of adsorption of metal complex and steps of exposure of the adsorbed metal complex to oxidizing gas. When a larger concentration of dimeric or trimeric metal is required, a first impregnation cycle with the first metal can be followed by a second impregnation cycle with the first metal. Preferably a second impregnation cycle is carried out with a metal complex providing a second metal.

The solid catalyst material is particularly useful for heterogeneous catalysis. The catalyst can be used for selective catalytic reduction (SCR). For example, nitrogen oxides, also referred to as NOₓ can be disposed of with the aid of the solid catalyst material. The NOₓ is transformed to diatomic nitrogen, N₂, and water, H₂O, using ammonia and a solid catalyst material. This catalysis process is useful in industrial boilers or solid waste boilers, diesel engines or gas turbines. A solid catalyst material is preferably settled in an elongated sponge-like filter structure. The solid catalyst particles can be the filler of a catalyst cube, through which the reactants like nitrogen oxide are guided for decomposition or transformation. The structure of the filter would look like a tube. At the same time, the structure is comparable with stacked honeycombs. The solid catalyst material can also be a catalyst for chemical synthesis. One example, where solid catalyst materials are particularly useful is a synthesis of hydrocarbons. The synthesis process can be similar to a Fischer-Tropsch process. Typical reactants for such a synthesis are carbonmonoxide and hydrogen, which are obtained e.g. from coal gasification, natural gas, bio mass or bio gas. Products can be alcohol, wax type materials or gaseous or liquid fuels.

The apparatus can have filters, which can also comprise pores, which are larger than a particle diameter of the solid particles. Such pores are preferably located in a gas feeding filter, which has a surface normal vector that is having an angle with a direction of the gravitational force. Thus a projection of the opening of the pore on this force vector gives an area that is smaller than a particle cross-section. With such a gas feeding filter, gas flow into the reactor can be improved. A gas feeding filter can also direct the gas flow into the fluidized bed reactor, e. g. to form a whirling gas flow inside of the reactor vessel. The pores can have a cross-section of a Laval nozzle. Still, the smallest cross-section of the pore preferably has a diameter smaller than a diameter of a solid particle. A nozzle design can be used to accelerate a flow of gas entering the reactor vessel. The pores can also have the shape of Venturi tubes, which can stabilize the mixture of a gas with a metal complex vapour on entering the reactor vessel. The reactor vessel can comprise at least two gas feeding filter, e. g. each gas feeding filter being used for a specific metal complex or a specific oxidizing gas.

A method to generate vapour is by heating a liquid or a solid. Vapour can also be generated by expanding a liquid from a first space having a first pressure into a second space having a pressure that is lower than the pressure of the first space, especially in combination with a heating device. A gas feeding filter can effect gas expansion. Vapourisation of liquid metal complex can at least be facilitated by a transition of a diameter of a conduit or a pore to a larger diameter.

In one embodiment, the reactor comprises an adsorption chamber and dissociation chamber so that adsorption and dissociation by oxidation e. g. of metal carbonyl takes place in separate fluidized reactor vessels. In another embodiment, the adsorption chamber and the dissociation chamber are located within the same reactor vessel, preferably having at least partially overlapping volumes. Separation of both chambers, of the adsorption chamber and the dissociation chamber, are useful for quasi-continuous production of solid catalyst material. If size and volume of the apparatus is limited, both processes, the process of adsorption and the process of dissociation, shall be conducted in the same chamber. An apparatus for production of solid catalyst material is particularly efficient, when it comprises at least one auxiliary unit or one additional component. A feeding device can be an auxiliary unit. The feeding device preferably comprises an activation system, in which solid material is chemically or physically pre-treated, e. g. to enhance adsorption of a first and/or a second metal complex. The activation system can comprise a heater or a vacuum pump that produces pressure below atmospheric pressure of 1000 hPa (hectopascal), preferably below 10 hPa. The activation system can also comprise a wet chemical stage for preparation of a surface or a surface layer like a zeolite layer of the solid material. An additional unit can be a heater connected with a reactor vessel. A heater may be useful to overcome activation energy for an exothermic oxidation process with oxidizing gases of poor reactivity or low reaction rate.

Another auxiliary unit can be a gas flow meter for keeping control over the flow of at least one gas into at least one chamber of the reactor vessel. Manual valve adjustments can be made based on meter readings. An additional unit could be a gas flow controller that is adjusting the flow of gas automatically. The gas can be a carrier gas, a metal complex vapour or an oxidizing gas. A gas flow controller preferably comprises a timer, which can set the time for adsorption process and/or the time for oxidation process of the metal complex. The timer can also set intervals for fluidization, when solid material particles are to be moved within the reactor. The gas flow meter or the gas flow controller can be operatively connected with the mixing stage.

Another auxiliary unit of an apparatus could be a waste material processing system that is connected with the reactor vessel. The waste material processing system removes possibly poisonous metal complex from the carrier gas flow. Especially near saturation of the solid material with metal complex, a considerable amount of metal complex remains in the gas flow. The waste material processing system can be a second stage of a fluidized bed reactor using solid material for filtering the carrier gas. The waste material processing system can also be a gas washer operatively connected with a gas exit filter. A gas washer can remove metal complex and products from oxidative decomposition of metal complex from gas flow, especially from gas leaving the reactor vessel through the gas exit filter or through a bypass. Also a vacuum pump operatively connected with a gas exit filter or connected with a gas feeding filter can be an additional unit of the fluidized bed reactor, which will help to speed up removal of excess metal complex before the reactor vessel is filled with oxidizing gas.

Furthermore, an agitator operatively connected with the reactor vessel can be an auxiliary device or an additional unit. A steering device with a rotor inside the reactor vessel or a conveying screw can be an agitator. Also a shaking device, e.g. a device that is changing the position of the reactor vessel or of the entire fluidized bed reactor can be an agitator. Other possible examples of agitators are a mechanical vibrator or an ultrasonic system that is coupling mechanical or acoustic energy into a reactor vessel. The agitator may rotate the reactor vessel, thus improve contact between solid material, solid catalyst material, and a fluid or a gaseous atmosphere.

When the apparatus is equipped with a gas circulation system as an auxiliary unit, which can be connected with the gas feeding filter and with the gas exit filter, the metal complex or the oxidising gas can be recycled. The amount of the material that needs to be treated as waste is reduced by recycling. In batch production, a predetermined amount of metal complex can be circulated through the reactor vessel until it is almost completely adsorbed in the solid material. The gas circulation system may comprise a heater to prevent condensation of metal complex on inner walls of the circulation system. Also a predefined mass of oxidizing gas can be circulated by the gas circulation system until the oxidizing gas is consumed by oxidation reactions. The gas circulation system comprises a gas pump capable of generating gas pressure used for feeding oxidizing gas, metal complex vapour and carrier gas or mixtures thereof. The circulation pump can comprise a gas flow controller.

Especially when the apparatus is a continuous production system for a solid catalyst material, the apparatus can comprise a transportation system, operatively connected with a reactor vessel. The transport system is preferably used for transporting impregnated solid catalyst materials through and away from the reactor vessel, thus maintaining a continuous flow of solid material. The transport system is preferably operating together with a feeding system for solid material. The solid catalyst material can be transported to a processing stage. The solid catalyst material can be transformed to a final product in the processing stage. An additional layer of material e. g. for promoting a reactive process can be added to the solid catalyst material in a flow-through reactor located downstream of the solid catalyst material. When the processing stage is a deposition device, solid catalyst material can be filled in a container or deposited or immobilized on a component of an engine or a gas purification system or the like. This can be done for further use e. g. in a catalytic reactor or catalytic purification system for liquids or for gases.

The apparatus can comprise a second fluidized bed reactor for solid material particles. The second fluidized bed reactor can comprise a gas adsorption chamber, especially a chamber for recovering metal complex from carrier gas. A second fluidized bed reactor can also be used as a decomposition chamber, e. g. when the apparatus comprises a branch for production of a first solid catalyst material and a branch for production of a second solid catalyst material.

The apparatus can further comprise a separation stage for solid catalyst particles. The separation stage is operatively connected to the reactor vessel. The separation stage, like a cyclonic separator and/or a filter for separation of particle size or diameter or other material properties can be used for production of different grades of solid catalyst particles. The different grades can also be produced in batches. Solid catalyst particles can be separated by identifying at least one difference in at least one parameter. Solid catalyst particles can have a different mass, a different size, a different volume or a different catalytic activity, which can be measured by a detection unit in the separation stage. A separation unit like a beam of compressed air can direct the solid catalyst particles from batch production or from continuous production into different collection units or containers or on different transportation systems or processing stages. In this way a most efficient production and efficient use of solid catalyst material can be achieved.

### Brief description of Figures

The understanding for present invention can be enhanced by referring to the following figures which may show additional inventive aspects by themselves, wherein
Fig. 1 shows a schematic flow chart of a batch process for production of solid catalyst material,
Fig. 2 shows a schematic flow chart for a continuous production process of solid catalyst material,
Fig. 3 shows a schematic flow chart of a continuous process with a counter flow option,
Fig. 4 shows a schematic flow chart for a continuous production process comprising a second production line,
Fig. 5 shows an apparatus in schematic presentation for the production of solid catalyst material,
Fig. 6 shows another example of an apparatus in schematic presentation for continuous production of solid catalyst material,
Figs. 7a and 7b depict two examples of solid catalyst material particles, measured with transmission electron microscopy,
Figs. 8a and 8b depict two transmission electron microscopy images of solid catalyst particles produced by thermal decomposition of iron carbonyl,
Fig. 9a shows an overview of zeolite catalyst particles produced with production method and apparatus according to the invention. Fig. 9b is a detailed view of two particles and Fig. 9c shows the image of Fig. 9b filtered for signals from iron content,
Fig. 10 shows measurements of adsorption of iron carbonyl on zeolite as a function of adsorption time and flow of iron carbonyl,
Fig. 11 shows measurements of iron content by EDX for different amounts of iron carbonyl adsorption on zeolite,
Fig. 12 shows optical UV-vis measurements of iron zeolites catalysts having two different Fe/Al-ratios,
Fig. 13 shows the Kubelka-Munk-transformation of optical UV-vis measurements of iron zeolite catalyst having 5.43 weight % iron, and
Fig. 14 shows the Kubelka-Munk-transformation of optical UV-vis measurements of iron zeolite catalyst having 1.61 weight % iron.

### Description of Figures

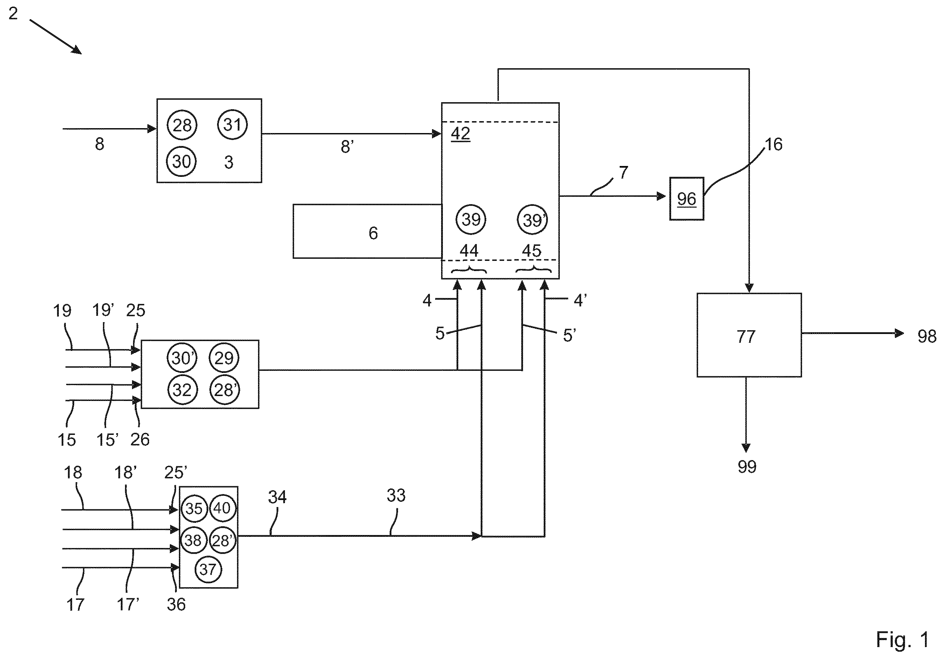

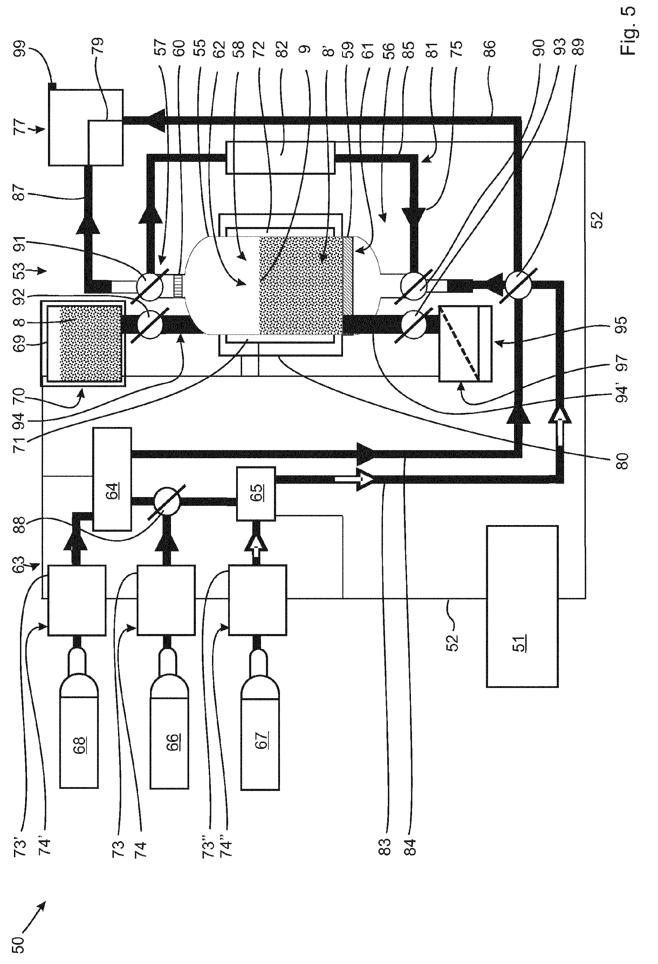

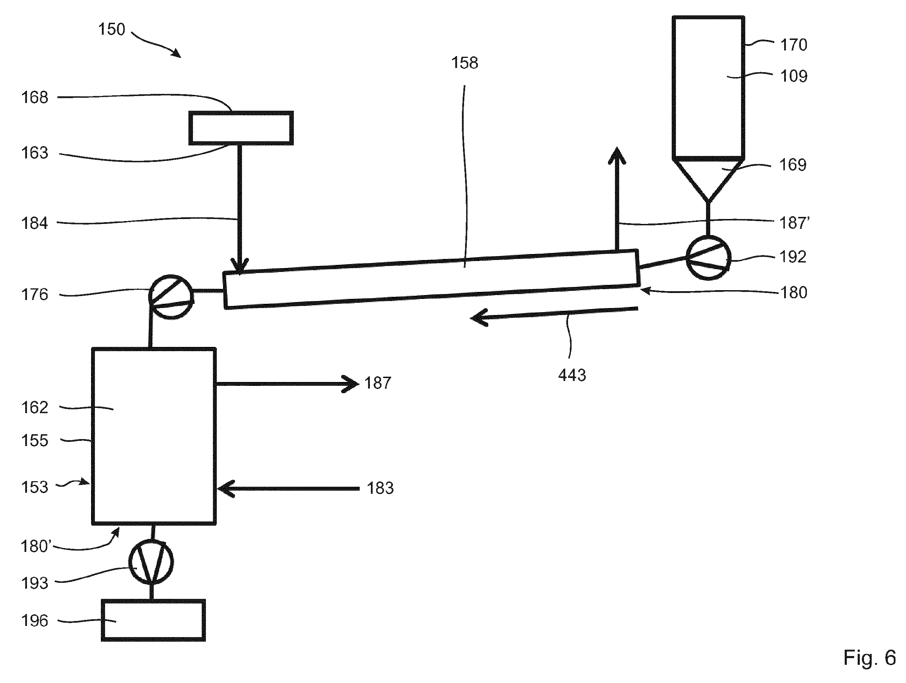

Several variations of production methods for solid catalyst materials based on this invention are shown in figures 1 to 4. The figures have many aspects of processes in common, which may not be described for each flow chart repeatedly, therefore figures 1 to 4 should be considered in combination with each other. Each flow chart shows functional features and behavioural features, which may be realized by an apparatus in accordance with figure 5 or an apparatus in accordance with figure 6.

The production process 2 of figure 1 has been designed for the production of pre-defined mass of solid material 8 like zeolite. In the beginning, the solid material 8 undergoes an activation step 3, in which at a given gas pressure 28, like the pressure of less than 14 torr, the solid material 8 is degassed, typically at a temperature 30 of 180 °C. The duration of the activation 31 can be about 18 hours. The activated solid material 8' is filled as a batch 42 in a reactor. After the activation step 3 the adsorption step 4 is carried out. Metal complex 15 is provided as a flow 26 into a mixing procedure, where the temperature 30' of the metal complex is stabilised above vapourisation temperature and below decomposition temperature of iron carbonyl. The expression "iron carbonyl" is an abbreviation for the term "iron pentacarbonyl". The vapour from metal complex 15 is mixed with a carrier gas 19, that is provided with a gas flow 25 in order to establish a constant partial pressure 29 of a metal complex 15 within a total gas pressure 28'. The metal complex thus diluted in the carrier gas 19 is fed into the reactor in order to expose the solid material 8 for the adsorption step 4. In this process, the temperature 39 of the solid material 8' is kept constant. For the production of solid catalyst material 7 in the first impregnation cycle 44 the decomposition step 5 has to be carried out after the adsorption step 4. When the adsorption time 32 is over, the duration time of vapour flow is ended. For the decomposition step 5, the decomposition gas 33 will be fed into the reactor in order to expose the batch of solid material 42 to an oxidizing gas concentration 34. The oxidizing gas concentration 34 was prepared by mixing air as deoxidizing gas 17 with nitrogen as a first carrier gas 18. The gas flow 25' of the first carrier gas 18 is combined with the oxidizing gas flow 36 of air. Thus, decomposition rate of the oxidizing gas 35 is adjusted and the partial pressure 37 of oxygen from air is further reduced. Furthermore, the temperature 38 of the oxidizing gas is controlled in order to make sure that the temperature of the solid material 39 in the reactor will stay below thermo decomposition temperature, when the batch 42 is exposed to decomposition gas 33. A typical value for the oxygen (O₂) concentration 34 is 0.15 vol.-% O₂ in two litres per minute of nitrogen (N₂). In samples performed by the applicant, a concentration of oxygen as oxidizing gas 34 of 20 vol.-% O₂ in 80 vol.-% N₂ was used and the oxidizing gas flow 36 was held at 3.833 litres per minute. For the first example, the duration of the oxidizing gas flow 40 was 18 hours. In the second example, the duration of the oxidizing gas flow 40 was 2 hours. In both examples, the temperature of the oxidizing gas 38 was stabilized at 20 °C (room temperature).

A list of production conditions for a number of batch production process examples is given in table 1. In table 1, control of iron content in the catalyst material is shown. Activated zeolite of similar quality is used for all samples. The carbonyl flow in milligram per minute was varied. Furthermore, the time for adsorption was varied on the scale of minutes. The adsorption can be monitored by measuring the weight gain in milligram of the material. Furthermore, the iron content can be monitored by EDX measurements after the adsorbed iron carbonyl has been decomposed by oxidation. The iron content is given in weight %. Samples produced with the homogenisation step 6 that can optionally be included in the production process of the solid catalyst material 7 shows that shaking the solid material 8' can significantly improve adsorption of iron carbonyl and thus reduce process time.

**Table I solid catalyst material produced using iron-pentacarbonyl and zeolite**

| Sample ID | Amount of activated zeolite^{a} [g] | Carbonyl flow [mg/min] | Argon flow [l/min] | Shaking device | Impregnation time [min] | Weight gain [mg] | EDX Fe content after oxidation^{b} [wt%] |
|---|---|---|---|---|---|---|---|
| Imp/ZeoS-01 | 1,85 | 60 | 2 | No | 30 | 496 | 4,8 |
| Imp/ZeoS-05 | 1,95 | 60 | 2 | No | 10 | 362 | 3,73 |
| Imp/ZeoS-06 | 1,98 | 60 | 2 | No | 5 | 252 | 3,5 |
| Imp/ZeoS-07 | 1,99 | 60 | 2 | No | 2,5 | 97 | 1,13 |
| Imp/ZeoS-10 | 1,86 | 60 | 2 | Yes | 13 | 506 | 5,55 |
| Imp/ZeoS-11 | 1,87 | 60 | 2 | Yes | 13 | 540 | 5,78 |
| Imp/ZeoS-12 | 1,85 | 60 | 2 | Yes | 6 | 364 | 4,65 |
| Imp/ZeoS-13 | 1,89 | 120 | 2 | Yes | 8 | 572 | 5,79 |
| Imp/ZeoS-14 | 1,93 | 180 | 2 | Yes | 7 | 552 | 4,91 |
| Imp/ZeoS-15 | 1,93 | 60 | 2 | Yes | 5 | 333 | 4,64 |
| Imp/ZeoS-16 h | 1,85 | 60 | 2 | Yes | 4 | 277 | |

| | | | | | | | |
|---|---|---|---|---|---|---|---|
| a Activation was performed under vacuum at 180 ° C br 18 h b Oxidation procedure: 1.) At RT, 0.15 vol.-% O₂ in 2 l/min of N₂ for 18 h; 2.) At RT, 20 vol.-% O₂ in N₂ at a combined flow of 0.833 l/min for 2 h | | | | | | | |

Tab. 1 shows a list of production examples of solid catalyst material using iron carbonyl and zeolite.

The production process 2 can simply be modified for using a second metal complex 15' with a second carrier gas 19' as an option. The second metal complex 15' is used after finishing the adsorption step 4 or after finishing the decomposition step 5 into the reactor. Another modification of process 2 that is easily achieved is feeding a second oxidizing gas 17' mixed with another carrier gas 18' into the reactor for a second decomposition step 5'. Several variations of the sequence of adsorption steps 4 and 4' and decomposition steps 5 and 5' are possible depending on the metal complexes 15, 15' and the oxidizing gas 17, 17' used for production of the solid catalyst material 7. The first carrier gas 18, 18' can be identical with a second carrier gas 19, 19', whereas first and second refer to the use as carrier gas for metal complex 15, 15' or for oxidizing gas 17, 17', respectively. The adsorption step 4' and decomposition step 5' are also named second impregnation cycle 45. The second impregnation cycle 45 can be carried out at a temperature of the solid catalyst material 39', which is higher or lower or identical with the temperature 39 of the solid catalyst material from the first impregnation cycle 44. The solid catalyst material 7 produced by the first impregnation cycle 44 and optionally the second impregnation cycle 45 is transferred to a deposition device 96 and immobilized on a support 16. Since the first impregnation cycle 44 and the second impregnation cycle 45 are flow-through procedures, the gas after exposure to the batch 42 is treated with a washing procedure 77 giving a gaseous component for the exhaust 99 and a liquid component 98 for waste disposal.

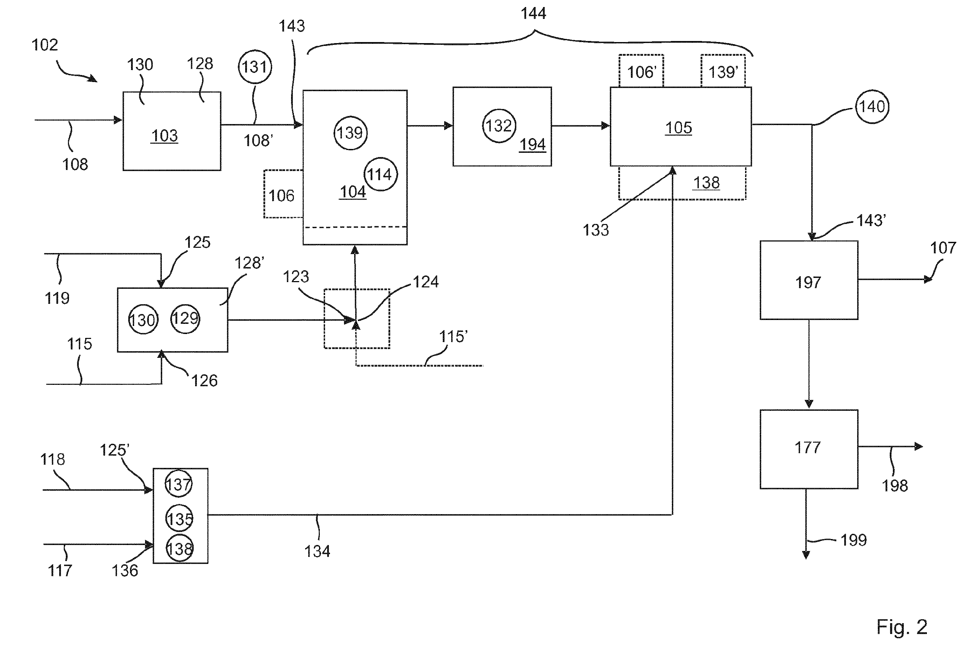

Figure 2 shows the flow chart of a continuous production process 102, which comprises some elements of a batch production process 2 in figure 1. In figure 2 the adsorption step 104 and the decomposition step 105 are carried out in separate reactor vessel at a distance from each other. A flow of solid material 143 from an activation step 103 through the impregnation cycle 144 is maintained, so that basically with the same flow solid material 143, 143' is fed into a cyclonic separation 197 and is filtered to obtain the solid catalyst material 107.

The activated solid material 108', in particular zeolite, is prepared continuously and the activation step 103 from solid material 108 takes place under controlled temperature 130 and gas pressure 128. The metal complex 115 iron carbonyl with a flow 126 is continuously evaporated under controlled temperature 130', which is also the temperature of the second carrier gas 119 of argon, that is mixed with the gas flow 125 to form a partial pressure of metal complex 129 at a total gas pressure 128'. Thus, a feeding concentration 123 of a first metal complex for the adsorption step 104 under the temperature of a solid catalyst material 139 is achieved.

As an option also another metal complex 115' can be fed with a concentration 124 of a second metal complex in the adsorption step 104. Another option of the production process 102 is the homogenisation step 106 that can be carried out during the adsorption step 104.

Since concentrations of metal complex 123, 124 are provided continuously, the duration of the vapour flow 132 from the adsorption step 104 is determined by the transportation system 194 delivering the solid material 108 through the adsorption step 104 and into the decomposition step 105. Also the decomposition time 114 is determined by the transportation system 194 while there is continuous flow of decomposition gas 133. The concentration 134 of the oxidizing gas in the decomposition gas 133 is controlled by the flow 136 of the oxidizing gas 117 and the flow 125' of the carrier gas 118 that is nitrogen. In this way the oxidizing gas composition 135 and the oxidizing gas partial pressure 137 can be controlled. Duration of oxidizing gas flow is indicated by reference number 140.

The decomposition step 105 can be further improved with the option of temperature control 138 of the decomposition gas 133. Furthermore the temperature of the solid material 139' can be controlled in the decomposition step 105. The quality of solid catalyst material 107 can be further improved by carrying out a homogenization step 106' in combination with the decomposition step 105, wherein the orientation of solid material 108' with absorbed metal complex 115, 115' is changed at least once before the flow of solid material 143' leaves the decomposition step 105.

Gases coming from the adsorption step 104 and the decomposition step 105 are led to a gas washing 177 for separation of exhaust gas 199 and liquid waste 198 for disposal.

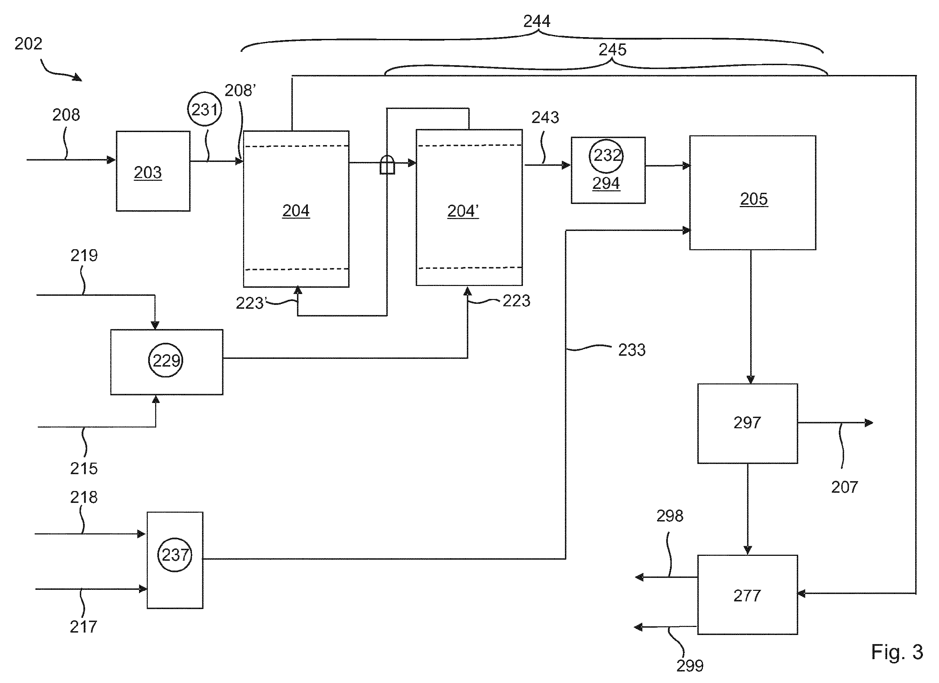

The continuous process 102 of figure 2 can be made even more efficient with a modification that is shown with the continuous process 202 of figure 3. The production process 202 comprises a first impregnation cycle 244 comprising the adsorption step 204 and the decomposition step 205. The production process 202 also comprises a second impregnation cycle 245 comprising the adsorption step 204', which can also be named a second adsorption step, and the decomposition step 205.

A continuous flow of the solid material 208 zeolite, transformed by activation step 203 into the solid material 208', is maintained through the impregnation cycle 244, 245, so that the continuous flow 243 reaches a cyclonic operation 297 and solid catalyst material 207 is obtained. The decomposition step 205 resembles the decomposition step 105 of figure 2, wherein adsorbed metal complex 215 of figure 3 is exposed to decomposition gas 233 within an oxidizing gas partial pressure 237 due to a mixture of the oxidizing gas 217 air with the first carrier gas 218 nitrogen. As described before, duration of the vapour flow 232 from the adsorption steps 204, 204' is determined by the transportation system 294 delivering the solid material 208 through the adsorption steps 204, 204' and into the decomposition step 205.

One advantage of the production process 202 is an efficient use of metal complex 215, so that the amount of liquid waste 298 for disposal that is obtained by waste material processing system 277 with a scrubber from gases of the impregnation cycle 244 is significantly reduced. This is achieved by feeding the metal complex 215 with a carrier gas 219 having a partial pressure 229 of metal complex vapour and therefore a controlled concentration 223 of metal complex first into the second impregnation cycle 245 where the second adsorption step 204' takes place. The second adsorption step 204' is carried out with a solid material 208', namely zeolite, that has already absorbed some metal complex 215. Adsorption is due to the first adsorption step 204, in which activated solid material 208' is exposed to metal complex 215 and a carrier gas 219. However, the concentration 223' of the metal complex 215 is already lowered by the fact that the metal complex 215 with a concentration 223 has already passed the second adsorption step 204'. Therefore the first adsorption step 204 will remove almost all metal complex 215 from the carrier gas 219.

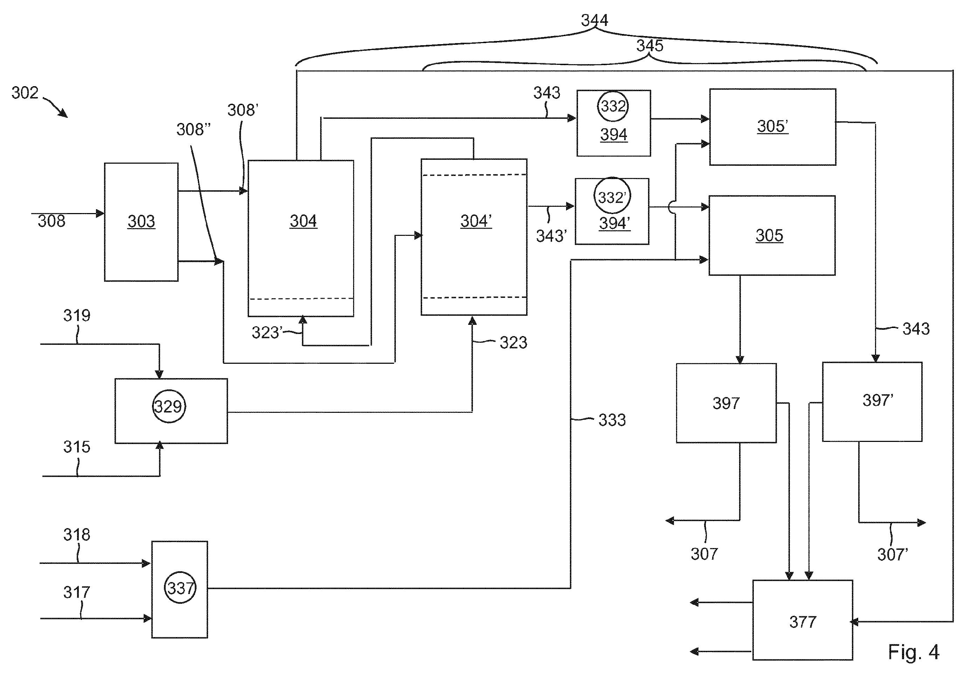

In figure 4 the production process 302 for continuous production of solid catalyst material 307, 307' can be made even more versatile by implementing a second production line in the production process 302.

The production process 302 comprises an activation step 303 for solid material 308, especially zeolites, and a step for preparation of partial pressure 329 of a metal complex 315 in a carrier gas 319 and a step of preparation of partial pressure 337 of an oxidizing gas 317 in a carrier gas 318. In the activation step 303 the temperature of the zeolite is controlled. Furthermore, the time of temperature exposure of zeolite can be controlled. Also the pressure and the gas composition, under which the zeolite is kept, can be controlled in the activation step 303.

The first line of production for solid catalyst material 307 starts with activated solid material 308' that is used in the first impregnation cycle 344 with a flow of solid material 343, that enters the separation stage 397 resulting in the separated solid catalyst material 307. As in the embodiments described before waste material is processed in a waste material processing system 377.

In the present process line the adsorption step 304 is carried out with a in comparison to the concentration 323 of metal complex 315 lower concentration 323' of metal complex 315 resulting from the optional step 304' of the second impregnation cycle 345 similar to production process 202 of figure 3 with a difference that in the production process 302 of figure 4 the first adsorption step 304 and the second adsorption step 304' are carried out on activated solid material 308', 308".

The adsorption time 332 of the first impregnation cycle 344 is controlled with a flow of solid material 343 by means of a first transportation system 394. The adsorption time 332' within the second impregnation cycle 345 is controlled with a flow of solid material 343' by means of a second transportation system 394'. The second impregnation cycle 345 is part of the second production line leading through a second decomposition step 305' to a second separation step 397' yielding a second solid catalyst material 307'. In each decomposition step 305, 305' the temperature of the respective solid catalyst material can be separately controlled. In each decomposition step 305, 305' the dwell time of the respective solid catalyst material can be controlled independent from each other. The gases from the adsorption steps 304, 304' and the from the decomposition steps 305, 305' are fed into a gas washer for treatment of waste material.

In the decomposition step 305, 305' adsorbed metal complex 315 of figure 3 is exposed to decomposition gas 333 within an oxidizing gas partial pressure 337 due to a mixture of an oxidizing gas 317, e.g. air, with a first carrier gas 318, e.g. nitrogen.

Figure 5 shows an example of an apparatus 50 that can be used for the production of solid catalyst material. The apparatus 50 comprises a fluidized bed reactor 53 and a gas mixing stage 63. The apparatus 50 comprises also a process control unit 51, which by means of a control line 52 can monitor and control a variety of parameters and functions of the fluidized bed reactor 53 and the gas mixing stage 63. Furthermore, the process control unit 51 can control the separation stage 97, the activation system 70 and the gas circulation system 81. Also, the waste material processing system 77 with a vacuum pump 79 can be switched by the process control unit 51.

The gas mixing stage 63 provides the gas for the metal complex line 84 and the gas for the oxidizing gas line 83, which are leading to the fluidized bed reactor 53. Gas flow from the carrier gas source 66, which is measured by a flow meter 73 and controlled by a gas flow controller 74, can be fed into the metal complex line 84 or into the oxidizing gas line 83 depending on the setting of the first valve 88, which is also named gas mixing valve. For the metal complex line, the carrier gas 66 drains the metal complex from metal complex source 68 within the vaporizer-mixer 64 comprising a source of heat. The flow of metal complex from the source 68 is monitored with a flow meter 73' and controlled with a flow controller 74'.

The gas flow controller 74 and the flow controller 74' together with a temperature generated in the vaporizer-mixer 64 determine the partial pressure of the metal complex under control of the process control unit 51. For pressures higher than vapour pressure of metal complex, such pressure can be adjusted by means of pressure from the first gas source 66 of carrier gas. The metal complex from the source 68 is guided through the second valve 89, which is also named gas feed valve and the third valve 90, which is also named gas circulation valve to the first end 56 of the reactor vessel 55 that is a core element of the fluidized bed reactor 53.

In another embodiment of an apparatus based on apparatus 50, the by-pass line 86 has been removed and the functions of the second valve 89 and the third valve 90 are combined in one single valve guarding the entrance of gas at the first end 56 of the reactor vessel 55 similar to the apparatus 50 of figure 5.

The second valve 89 of apparatus 50 can interrupt the gas flow through the metal complex line or direct the gas flow from the metal complex line 84 into the by-pass line 86 leading to the vacuum pump 79 or into the waste material processing system 77, where carrier gas 66 and metal complex 68 are separated and carrier gas 66 leads through the exhaust 99.

The gas for the oxidizing gas line 83 is mixed in a thermostat-mixer 65. For this effect the first valve 88 interrupts the gas line from the carrier gas source 66 to the vaporizer-mixer 64 and opens the connection to the thermostat-mixer 65. The flow of carrier gas is again adjusted by the flow controller 74 and monitored by the gas flow meter 73. Also, the pressure of the first gas source 66 of carrier gas can be adjusted. Furthermore, oxidizing gas from a second gas source 67 is fed into the thermostat-mixer 65 with a flow controlled by a gas flow controller 74" and monitored with a flow meter 73" and a pressure from the second gas source 67 which is also adjusted by means of the process control unit 51. The partial pressure of carrier gas 66 and oxidizing gas 67 is adjustable by means of pressures and flow into the thermostat-mixer 65. The thermostat-mixer 65 can set a temperature of the gas in the oxidizing gas line 83 by means of a cooler to e. g. 0 °C or below. The thermostat-mixer 65 also comprises a heater, which can be used to heat-up the gas provided through the oxidizing gas line to a temperature below the decomposition temperature of metal complex from the metal complex source 68. The oxidizing gas line 83 is also connected to the second valve 89, which can be opened for the oxidizing gas to enter the reactor vessel 55 through the third valve 90.

At the first end 56 of the reactor vessel 55 is the gas feeding filter 59, which has a plurality of pores so that gas coming through the third valve 90 can enter the gas adsorption chamber 58 or the decomposition chamber 62. Either metal complex from the metal complex source 68 or oxidizing gas from the oxidizing gas source 67 is fed through the gas feeding filter 59 into the reactor vessel 55 thus using the reactor vessel 55 as gas adsorption chamber 58 or decomposition chamber 62, respectively. First metal complex 68 flows through activated solid material 8' inside the reactor vessel 55 for adsorption. Then, the flow of metal complex 68 is interrupted by the second valve 89 and flow of oxidizing gas 67 is brought into contact with metal complex 68 adsorbed on the activated solid material 8'. The cooler 71 or a heater 72 disposed around the reactor vessel 55 can be used to stabilize the temperature of the activated solid material 8' inside the reactor vessel 55. An agitator 80, which is also disposed on the reactor vessel, can be used to shake the reactor vessel 55 and thus change the position of particles 9 of solid material 8'. An alternative form of agitation that can be applied to the solid material 8' is a pulse of gas pressure from the first gas source.

Particles 9 of solid material 8' that are lifted up inside the reactor vessel 55 are held back by the gas exit filter 60 at the second end 57 of the reactor vessel 55. Gas is flowing through the gas adsorption chamber 58 and through the decomposition chamber 62 from the gas feeding filter 59 to the gas exit filter 60, which comprises pores, through which the gas can reach the forth valve 91, also named gas exit valve. From the forth valve 91 the gas can enter the gas exit line 87 and continue into the waste material processing system 77 also driven by the vacuum pump 79.

The efficiency of the apparatus 50 is further underlined by the fact that the gas flow from a gas exit filter 60 can also be directed into the gas circulating system 81 by switching the forth valve 91. In addition, the third valve 90 locks the conduit to the second valve 89 and opens the gas flow of the circulation line 85 with a flow direction 75 from the forth valve 91 to the third valve 90 and back into the reactor vessel 55 through the gas feeding filter 59. The pores 61 of the gas feeding filter 59 are small enough that solid material 8' is held back inside the reactor vessel 55.

The gas circulation system 81 comprises a gas pump 82, which controls the gas flow and the pressure at the first end 56 of the reactor vessel 55. The gas circulation system 81 can be used for gas provided through the metal complex line 84 or for gas provided through the oxidizing gas line 83. In this way especially rare and expensive metal complex can be recycled and used up most efficiently. Less waste material from the waste material processing system 77 is obtained. In such a configuration also the gas from the exhaust 99 could be recycled as carrier gas for the carrier gas source 66.

After impregnation with metal, the solid material 8' leaves the fluidized bed reactor 53 and the reactor vessel 55 through a transportation system comprising a sixth valve 93, also named solid catalyst feed valve. The solid catalyst material is delivered by the transportation system 94' to the separation stage 97 comprising a cyclonic separator and a filter and further on to processing stage 95 for production of a final product comprising a solid catalyst material.

By using a second transportation system 94 the activated solid material 8' enters the reactor vessel and the flow of the solid material 8' can be controlled by the fifth valve 92, also named solid material feed valve, and the feeding device 69. The feeding device 69 is connected with an activation system 70, in which solid material 8 is treated under a flow of gas or a vacuum by a temperature of typically more than 100 °C. Activation is achieved e. g. by removing water from solid material 8. Other activation steps can be carried out e. g. steps for formation of a zeolite layer on a mezzo-porous carrier material.

Examples for useful types of zeolites are zeolites with a BEA framework structure having cavity diameters of around 0.668 nm and pore diameters of around 0.595 nm. A typical water loss (LOI) at 1000 °C is 1.1 wt%. The surface area according to BET theory is 660 m²/g (square metre per gram). The average particle size can be on a micrometre-scale with a particle size distribution having 50 % of the particles within 9.5 µm, and 90 % of the particles within 19.4 µm. Melting point is above 400 °C and density is 2.2 g/cm³ (gram per cubic centimetre).

Figure 6 shows a design for an apparatus 150, which is particularly useful for continuous metal carbonyl impregnation of particles 109 like particles of 100 to 200 µm size or ceramic pellets, which are spherical of 3 mm diameter or beads, which have 8 mm length and 3 mm diameter. The design of the apparatus 150 provides a capacity in the range of 15 to 25 kg or 7 to 12 litre. The activation system 170 prepares the particles 109 for use and a feeding device 169 in connection with a solid material feed valve 192 delivers the particles 109 into the gas adsorption chamber 158. A typical residence time in the rotary gas adsorption chamber 158, which can also function as a kiln or a cooler, is 5 to 10 minutes The length of the gas adsorption chamber 158 can be in the 5 meter range to provide a sufficiently large surface area available for the metal carbonyl impregnation, so that 150 kg per hour or 1000 tons per year of impregnated solid material particles can be produced. A metal carbonyl gas generator 168 is used as a source for the metal complex. A gas mixing stage 163 prepares the feed gas for adsorption, which enters the gas adsorption chamber 158 through the metal complex line 184. Carrier gas mixed with excess metal complex is disposed of through exit line 187', e. g. by means of a pump unit and a washer (not shown). The solid material particles inside the rotary gas adsorption chamber 158 are transported by an agitator 180, comprising a rotator and a screw (not shown), thus forming a flow of solid material 443. The flow of solid material 443 is guided through a feed control valve 176 into a reactor vessel 150 where the metal carbonyl, which is adsorbed to the particles 109, is instantly oxidized. The process is carried out in a fluidized bed reactor 153. Oxidizing gas is fed into the reactor 153 through the oxidizing gas line 183. Unused oxidizing gas is pumped away through the exit line 187. The agitator 180' supports the reaction inside the decomposition chamber 162. The flow of solid catalyst material (not shown) is then controlled with the solid catalyst feed valve 193 and the catalyst, like a Fischer-Tropsch catalyst, is collected in the deposition device 196. A Fischer Tropsch catalyst based on cobalt and a respective cobalt carbonyl produced with a similar apparatus would suit a facility with an output of 20,000 bbl (barrel) of liquid hydrocarbon per day. The spherical alumina pellet of 3 mm can contain 15 % cobalt in a thin radial section of 0.2 mm. In this case, only 20 % of the pellet would be impregnated with cobalt. With a package density of the pellets of about 64 % of the total volume, the cobalt content is approximately 0.05 kg per 1 kg of solid catalyst material. The production capacity of the reactor can be upscaled or down scaled.

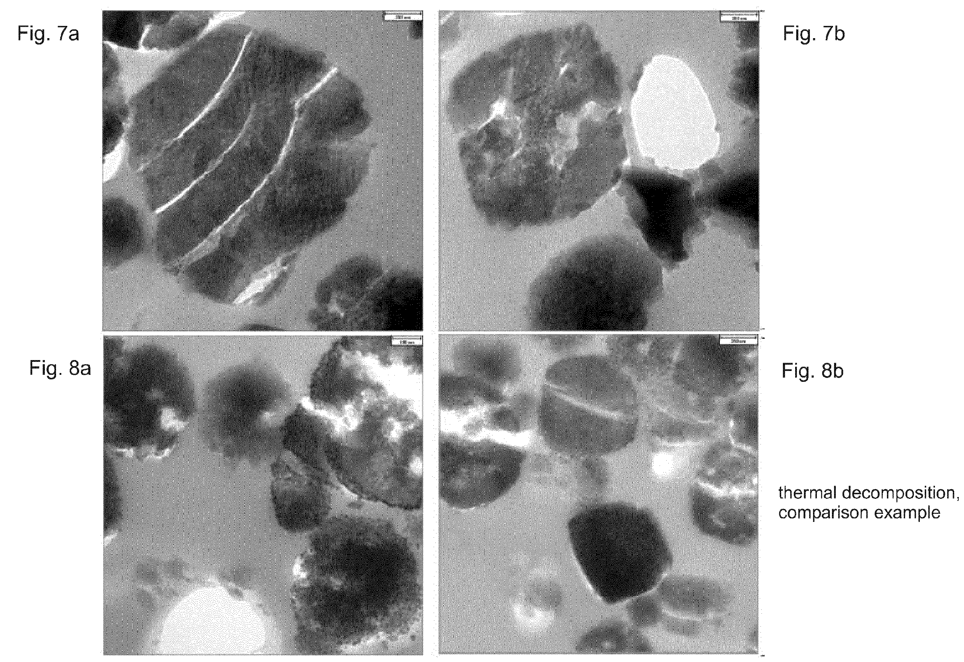

The figures 7a and 7b show in their images two examples of transmission electron microscopy images with a marker scale of 200 nm. The zeolite particles shown have a diameter of about 1 µm. Pores and cavities are smaller than the resolution of the TEM-image. The samples of catalyst materials were produced with a reactor of the type described in figure 5 and the process described in figure 1. Iron carbonyl was absorbed within 10 minutes of exposure of iron carbonyl vapour to activated zeolite. An amount of 186 mg iron carbonyl per 1 g zeolite was measured with a balance. The iron content of the solid catalyst material was measured by EDX-spectroscopy to 3.73 % of the total weight of the solid catalyst material. Thus, because of the oxidation method applied almost no iron deposits on the outer surface in the form of iron nano-particles are visible.

For comparison, a sample of solid catalyst material was produced from iron carbonyl and zeolite using the same type of zeolite and TEM-micrographs. The results are shown in figures 8a and 8b having the same resolution as figures 7a and 7b. Thus, some of the decomposition process and absorption time of 5 minutes was used and an amount of 68 mg per 1 g zeolite material was measured by a balance. The EDX analysis of the iron content gave a value of 1.59 weight %.

Though the iron content from the sample produced for the thermo decomposition example is significantly lower than the iron content of the sample in figures 7a and 7b, many particles of iron can be served on the size scale of less than 20 nm, which are formed on the outer surface of the zeolite particles. The particles are most obvious in the bottom right corner of figure 8a. The comparison of figure 7 and figure 8 shows that some of the decomposition method produces a larger amount of iron particles on the outer surface as compared to the oxidation method, which allows keeping the sample temperature of the absorbed iron carbonyl on the zeolites near room temperature.

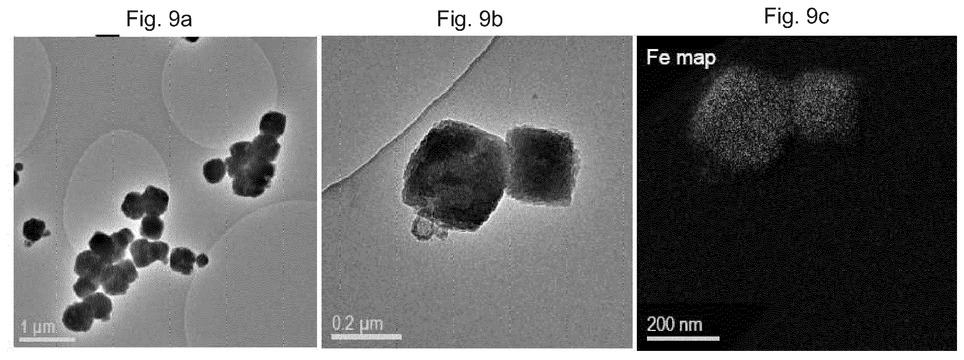

The figures 9a, b and c show a more detailed study of iron zeolite solid catalyst material particles, which were produced by absorption of iron carbonyl followed by a step of oxidation. The impregnation time of 30 minutes used gave an amount of 267 mg iron carbonyl per 1 g zeolite material. With the EDX-method an iron content of 4.8 weight % was measured. Figure 9a shows an overview over a sample of particles with a size slightly below 1 µm as shown by the included scale. Figure 9b is a close-up of figure 9a showing two particles of solid catalyst material close to each other. The same section was measured again by using a filtering technique, which exploits the fact that electrons interacting with iron loose some of the initial energy. This energy loss identifies the iron content within the image. Obviously, iron is well distributed over the two particles of figure 9b as shown in figure 9c. In figures 9a and 9b there is no indication of formation of iron nano-particles or agglomerations of iron nano-particles in the vicinity of the solid catalyst material. Therefore it can be concluded that a large amount of the iron content measured is distributed over the inner surfaces of the solid catalyst particles.

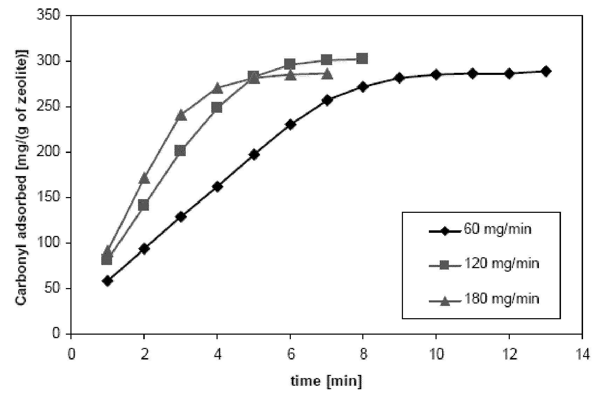

Figure 10 shows three curves for three different flow conditions of iron carbonyl over a zeolite sample. The diamond symbol indicates measurements with a flow of 60 mg per minute, the square symbol indicates a flow of 120 mg per minute and the triangle symbol indicates a flow of 180 mg per minute. The measurements are shown as a function of exposure time on a scale of up to 14 minutes. For the concentration of 60 mg per minute, there is a linear increase in the amount of carbonyl adsorbed after a given time up to a time of about 7 minutes. For longer time the amount of adsorbed carbonyl remains constant. A similar behaviour was obtained for the flow of 120 mg per minute, where the saturation effect of adsorption is reached already after less than 5 minutes. With 180 mg per minute, the saturation in iron carbonyl absorption shows at after about 3 minutes. Within the linear increase of adsorption, the amount of iron carbonyl adsorbed in the zeolite sample can be well controlled therefore providing an exact means for depositing a pre-defined amount of iron on the inner surface of a solid material like zeolite.

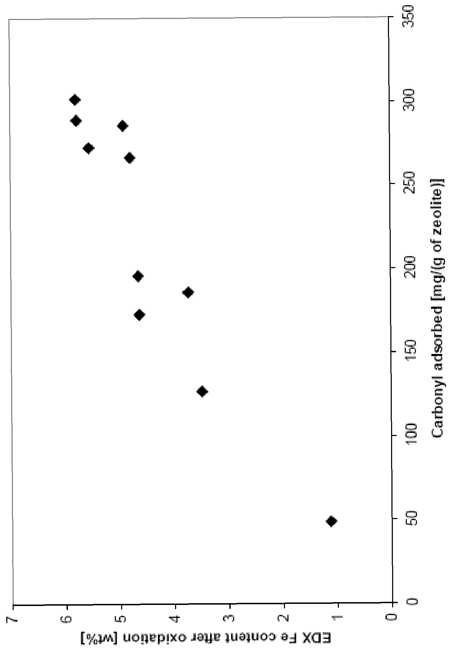

Figure 11 gives some additional evidence for the good control over solid catalyst materials produced with the production method and the reliability of the apparatus for control of production parameters. Measurements from a number of different samples produced are compared. Adsorption conditions of iron carbonyl were changed in order to control the amount of adsorbed metal carbonyl on the surface of the zeolite particles. The amount of adsorbed iron carbonyl was measured with a balance. The iron content after the decomposition step with oxidizing gas was measured with the EDX method, namely the energy dispersion of X-rays generated by electron impact. The EDX method is a method well known in the art. EDX is the abbreviation for energy dispersive X-ray spectroscopy. When the amount of iron carbonyl adsorbed to the zeolite is doubled also the iron content produced by oxidative decomposition of the iron carbonyl is doubled, which means that desorption of iron carbonyl in the decomposition step is negligible.

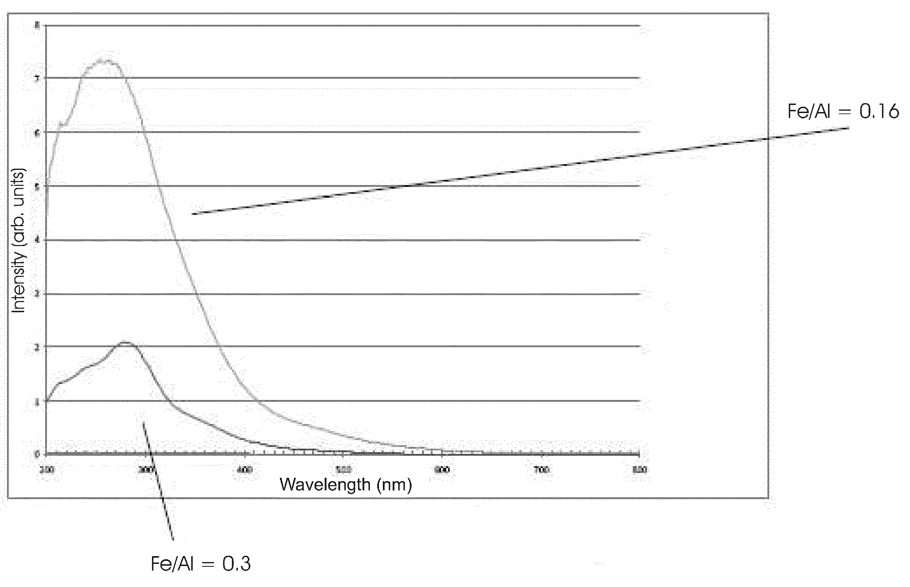

Another aspect of the good quality of the solid catalyst material produced is illustrated in Figure 12. UV-vis adsorption spectra were measured for three samples. First the pristine activated zeolite was measured giving a baseline signal. The spectrum measured for a ratio of iron (Fe) / aluminium (Al) of 0.16, which is a low content of iron, has a maximum at around 260 nm wavelength and a rather steep decline towards longer wavelengths. The spectrum can be attributed to a presence of a high density of monomeric and dimeric species of metal in the solid catalyst material. Another optical spectrum measured for a sample of solid catalyst material using the same type of zeolite but a double content of iron with a ratio of Fe/Al of 0.3. The spectrum shows several differences compared with the lower iron content. The maximum adsorption in the spectrum appears to be slightly shifted towards longer wavelengths by about 10 nm. A shoulder between wavelengths of 330 nm and 450 nm can be identified in the spectrum. These spectral differences can be attributed to the presence of oligomer particles of iron, which is due to the higher content of iron. The conclusions are based on simulations of optical spectra.

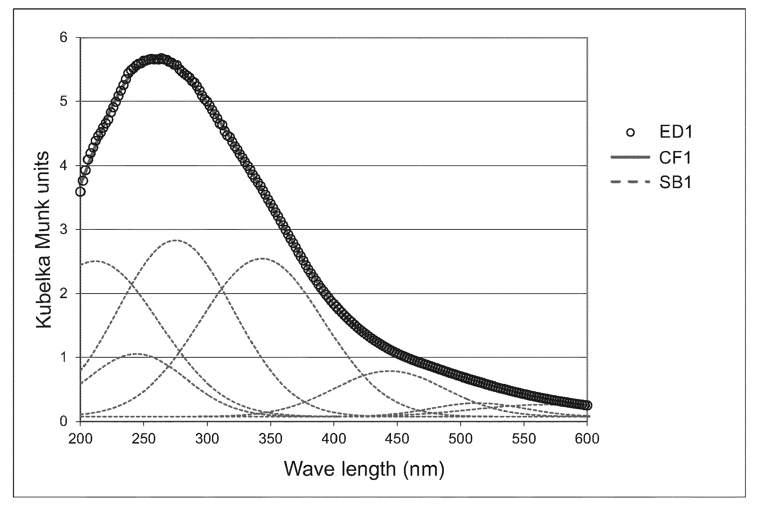

Figure 13 shows experimental data from diffuse reflectance spectroscopy (DRS) of a zeolite based catalyst. The data ED1 are presented in standard Kubelka Munk transformation, based on approximations due to the Kubelka Munk theory. Solid catalyst material produced using this invention, having 5.43 % iron on zeolite as compared to 100 % of the total weight of the solid catalyst material, was used for the measurement. The dotted lines show sub-bands SB1 related to optical transitions of iron containing species, which contribute to the spectroscopic signal. The peaks were optimised in order to obtain a best cumulative fit CF1 curve following the experimental data points. The different sub-bands SB1 are located at 212 nm, 244 nm, 275 nm, 343 nm, 444 nm 514 nm and 568 nm. Sub-bands below a wavelength of 280 nm in the spectrum are typically attributed to monomeric Fe³⁺ ionic species of single iron. Sub-bands in the wavelength region between 280 nm and 400 nm are typically assigned to a mixture of Feₓ³⁺O_{y} oligomers, whereas the values of Kubelka Munk intensity at wavelengths higher than 400 nm are caused by Fe₂O₃ cluster particles. The evaluation of the peak area gave a distribution of 63 % monomeric Fe³⁺, 26 % oligomers and only 11 % cluster particles of a total of 100 % particles measured with UV-vis diffuse reflectance spectroscopy.

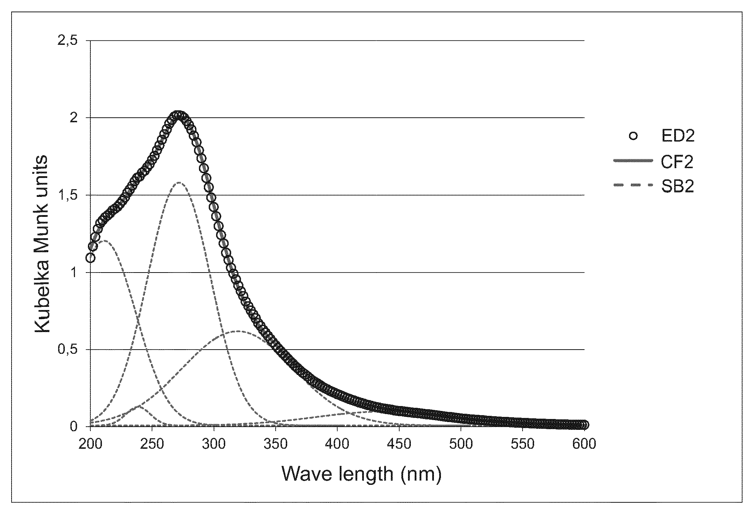

Another example of diffuse reflectance spectroscopy is shown in figure 14. The 100 weight % solid catalyst material had only 1.61 weight % iron on zeolite. This material was produced with a similar method compared to the sample measured in figure 13. Figure 14 shows Kubelka Munk transformed experimental data ED2 as circles, the best cumulative fit CF2 curve as solid line and the different sub-bands SB1 in broken lines. The peaks of the sub-bands are located at 211 nm, 239 nm, 272 nm, 319 nm and 438 nm, respectively. The evaluation of the peak area gave a distribution of 69 % monomeric Fe³⁺, 26 % oligomers and only 5 % cluster particles of a total of 100 % particles measured with UV-vis diffuse reflectance spectroscopy.

Production parameter and size ranges, materials or morphologies of solid catalyst materials with metal impregnation given are not representing technical limitations of the apparatus and production process of this invention. Different aspects described in one example can be freely combined with aspects of other examples within the scope of this invention.

**Reference signs**

| Reference Numeral | Significance |
|---|---|
| 2, 102, 202, 302 | Production process |
| 3, 103, 203, 303 | Activation step |
| 4, 4', 104, 204, 204', 304, 304' | Adsorption step |
| 5, 5', 105, 205, 305, 305' | Decomposition step |
| 6, 106, 106' | Homogenisation step |
| 7, 107, 207, 307, 307' | Solid catalyst material |
| 8, 8', 108, 108', 208, 208', 308, 308', 308" | Solid material, especially zeolite |
| 9, 109 | Particle |
| 114 | Decomposition time |
| 15, 15', 115, 115', 215, 315 | Metal complex |
| 16 | Support |
| 17, 17', 117, 217, 317 | Oxidizing gas |
| 18, 18', 118, 218, 318 | First carrier gas |
| 19, 19', 119, 219, 319 | Second carrier gas |
| 123, 223, 223', 323, 323' | Concentration of a first metal complex |
| 124 | Concentration of a second metal complex |
| 25, 25', 125, 125' | Gas flow, especially flow of a carrier gas |
| 26, 126 | Vapour flow, especially flow of metal complex |
| 28, 28', 28", 128, 128' | Gas pressure |
| 29, 129, 229, 329 | Vapour partial pressure, especially partial pressure of metal complex |
| 30, 30', 130, 130' | Temperature of a gas |
| 31, 131, 231 | Duration of activation, especially activation time |
| 32, 132, 232, 332, 332' | Duration of vapour flow, especially adsorption time |
| 33, 133, 233, 333 | Decomposition gas |
| 34, 134 | Oxidizing gas concentration |
| 35, 135 | Oxidizing gas composition |
| 36, 136 | Oxidizing gas flow |
| 37, 137, 237, 337 | Oxidizing gas partial pressure |
| 38, 138 | Temperature of the oxidizing gas |
| 39, 39', 139, 139' | Temperature of the solid catalyst material, especially Temperature of the solid material |
| 40, 140 | Duration of the oxidizing gas flow, especially decomposition time |
| 42 | Batch of solid material |
| 143, 143', 243, 343, 343', 443 | Flow of solid material |
| 44, 144, 244, 344 | First impregnation cycle |
| 45, 245, 345 | Second impregnation cycle |
| 50, 150 | Apparatus |
| 51 | Process control unit |
| 52 | Control line |
| 53, 153 | Fluidized bed reactor |
| 55, 155 | Reactor vessel |
| 56 | First end |
| 57 | Second end |
| 58, 158 | Gas adsorption chamber |
| 59 | Gas feeding filter |
| 60 | Gas exit filter |
| 61 | Pores of the filter |
| 62, 162 | Decomposition chamber |
| 63, 163 | Gas mixing stage |
| 64 | Vaporizer-mixer |
| 65 | Thermostat-mixer |
| 66 | First gas source, especially carrier gas |
| 67 | Second gas source, especially oxidizing gas |
| 68, 168 | Metal complex source, especially carbonyl gas generator |
| 69, 169 | Feeding device |
| 70, 170 | Activation system |
| 71 | Cooler |
| 72 | Heater |
| 73, 73', 73" | Flow meter, especially gas flow meter |
| 74, 74', 74" | Flow controller, especially gas flow controller |
| 75 | Gas flow direction |
| 176 | Feed control valve |
| 77, 177, 277, 377 | Waste material processing system, especially washing of gas |
| 79, | Vacuum pump |
| 80, 180, 180' | Agitator |
| 81 | Gas circulation system |
| 82 | Gas pump |
| 83, 183 | Oxidizing gas line |
| 84, 184 | Metal complex line |
| 85 | Circulation line |
| 86 | Bypass line |
| 87, 187, 187' | Exit line |
| 88 | First valve, especially gas mixing valve |
| 89 | Second valve, especially gas feed valve |
| 90 | Third valve, especially gas circulation valve |
| 91 | Fourth valve, especially gas exit valve |
| 92, 192 | Fifth valve, especially solid material feed valve |
| 93, 193 | Sixth valve, especially solid catalyst feed valve |
| 94, 94', 194, 294, 394, 394' | Transportation system, especially transport of solid catalyst material |
| 95 | Processing stage |
| 96, 196 | Deposition device, especially deposition |
| 97, 197, 297, 397, 397' | Separation stage, especially cyclonic separation |
| 98, 198,298 | Liquid waste disposal |
| 99, 199,299 | Exhaust |
| | |
| ED1, ED2 | Transformed experimental data |
| CF1, CF2 | Cumulative fit to experiment |
| SB1, SB2 | Sub-bands |

## Claims

1. Production process (2, 102, 202, 302) of a solid catalyst material (7, 107, 207, 307, 307')
using a solid material (8, 8', 108, 108', 208, 208', 308, 308', 308"),
having at least one pore or at least one cavity,
the pore or the cavity having one diameter of less than 1 µm, preferably less than 50 nm, more preferably less than 2 nm,
like a mesoporous silica based material, a zeolite, a metallic foam, an alumina or titania based material, an activated carbon or high surface area carbon material such as expanded graphite, nano graphite, graphene or a few graphene layer structure, which is exposed to a metal complex (15, 15', 115, 115', 215, 315), like metal carbonyl molecules or metal organic compounds, entering the pore or cavity, wherein the solid material (8, 8', 108, 108', 208, 208', 308, 308', 308") is impregnated with metal by the following production process steps:
- adsorption of the metal complex (15, 15', 115, 115', 215, 315) in the pore or in the cavity of the solid material (8, 8', 108, 108', 208, 208', 308, 308', 308"), and
- decomposition of the metal complex (15, 15', 115, 115', 215, 315) by means of oxidation due to exposure to oxidizing gas (17, 17',117, 217, 317), like air, oxygen, a halogene or ammonia, preferably mixed with a first carrier gas (18, 18', 118, 218, 318), entering the pore or cavity, wherein metal from the metal complex (15, 15', 115, 115', 215, 315) is attached to a surface of the solid material (8, 8', 108, 108', 208, 208', 308, 308', 308"),
**characterized in that**
in the step of adsorption, temperature (39, 39', 139, 139') of the solid material (8, 8', 108, 108', 208, 208', 308, 308', 308") is controlled at a temperature below a room temperature of 25 °C,
metal is bond to the surface of the solid material (8, 8', 108, 108', 208, 208', 308, 308', 308") at least in part along the pore or the cavity,
and at least some of the structures enclosing the pore or the cavity bind metal dispersed as monomeric species or dimeric species of metal or metal bound to the oxidizing gas (17, 17',117, 217, 317), preferably forming a bi-functionalized catalyst surface,
whereby all monomeric species exceed all oligomeric species by number.

2. Production process (2, 102, 202, 302) of a solid catalyst material (7, 107, 207, 307, 307') in accordance with claim 1, further **characterized in that** adsorption of the metal complex (15, 15', 115, 115', 215, 315) is controlled by at least one of the following:
a metal complex (15, 15', 115, 115', 215, 315) concentration or a concentration of a first metal complex (123, 223, 223', 323, 323') and a concentration of a second metal complex (124), preferably in a second carrier gas (19, 19', 119, 219, 319),
a gas flow (25, 25', 125, 125') or a vapour flow (26, 126),
a gas pressure (28, 28', 28", 128, 128') or a vapour partial pressure (29, 129, 229, 329),
a temperature of a gas (30, 30', 130, 130') and/or
a temperature of the solid material (8, 8', 108, 108', 208, 208', 308, 308', 308"),
preferably above a liquid or solid metal complex vaporization temperature, and/or
a duration of the vapour flow (32, 132, 232, 332, 332').

3. Production process (2, 102, 202, 302) of a solid catalyst material (7, 107, 207, 307, 307') in accordance with claim 1 or claim 2, further **characterized in that** decomposition of metal complex is controlled by at least one of the following:
a metal complex concentration in the solid material (8, 8', 108, 108', 208, 208', 308, 308', 308"),
an oxidizing gas concentration (34, 134), preferably less than 1 % of a decomposition gas,
an oxidizing gas composition (35, 135),
an oxidizing gas flow (36, 136),
an oxidizing gas partial pressure (37, 137, 237, 337),
a temperature of the oxidizing gas (38, 138) and/or
a temperature of the solid catalyst material (39, 39', 139, 139'), preferably below a metal complex decomposition temperature in at least 90 % of the mass of the solid material (8, 8', 108, 108', 208, 208', 308, 308', 308"),
a duration of the oxidizing gas flow (40, 140).

4. Production process (2, 102, 202, 302) of a solid catalyst material (7, 107, 207, 307, 307') in accordance with any one of the preceding claims, further **characterized in that** the metal complex (15, 15', 115, 115', 215, 315) comprises a transition metal like iron, nickel, cobalt, copper, zinc, especially a precious metal like platinum or palladium.

5. Production process (2, 102, 202, 302) of a solid catalyst material (7, 107, 207, 307, 307') in accordance with any one of the preceding claims, further **characterized in that** impregnation of the solid material (8, 8', 108, 108', 208, 208', 308, 308', 308") with metal is executed in a batch of solid material (8, 8', 108, 108', 208, 208', 308, 308', 308"), especially along gas conveying pores or cavities guiding through the solid material (8, 8', 108, 108', 208, 208', 308, 308', 308"),
an overall temperature of the batch during impregnation is kept in or below a room temperature range, especially at or below 0 °C, more preferably below -20 °C, and most preferably below -60 °C, but still above a condensation temperature range of the metal complex (15, 15', 115, 115', 215, 315).

6. Production process (2, 102, 202, 302) of a solid catalyst material (7, 107, 207, 307, 307') in accordance with any one of the preceding claims, further **characterized in that** the metal complex (15, 15', 115, 115', 215, 315) is fed in a steady and continuously flow of argon, especially in quantities of 100 mg, preferably 30 mg per minute and per g solid material (8, 8', 108, 108', 208, 208', 308, 308', 308").

7. Production process (2, 102, 202, 302) of a solid catalyst material (7, 107, 207, 307, 307') in accordance with any one of the preceding claims, further **characterized in that** during a phase of adsorption of the metal complex (15, 15', 115, 115', 215, 315) the solid material (8, 8', 108, 108', 208, 208', 308, 308', 308") is moved at least once.

8. Production process (2, 102, 202, 302) of a solid catalyst material (7, 107, 207, 307, 307') in accordance with any one of the preceding claims, further **characterized in that** the solid material (8, 8', 108, 108', 208, 208', 308, 308', 308") consists of particles or the solid material (8, 8', 108, 108', 208, 208', 308, 308', 308") comprises at least one particle,
of which at least one particle has a diameter of less than 50 µm, preferably less than 1 µm, in at least one direction.

9. Production process (2, 102, 202, 302) of a solid catalyst material (7, 107, 207, 307, 307') in accordance with claim 8, further **characterized in that** at least one particle of the solid material (8, 8', 108, 108', 208, 208', 308, 308', 308") is fixed to a support, like a pipe, a honeycomb structure, a cordierite, or a metallic foam.

10. Production process (2, 102, 202, 302) of a solid catalyst material (7, 107, 207, 307, 307') in accordance with any one of the preceding claims, further **characterized in that** the adsorption of the metal complex (15, 15', 115, 115', 215, 315) in the solid material (8, 8', 108, 108', 208, 208', 308, 308', 308") is preceded by a production process step of surface activation of the solid material (8, 8', 108, 108', 208, 208', 308, 308', 308"), e.g. by means of drawing a vacuum and preferably by heating the solid material (8, 8', 108, 108', 208, 208', 308, 308', 308") especially to a temperature above 100 °C.

11. Production process (2, 102, 202, 302) of a solid catalyst material (7, 107, 207, 307, 307') in accordance with any one of the preceding claims, further **characterized in that** the impregnation of the solid material (8, 8', 108, 108', 208, 208', 308, 308', 308") with metal is carried out continuously, in particular providing a flow of particles of solid catalyst material (7, 107, 207, 307, 307'), especially by controlling the flow of metal complex (15, 15', 115, 115', 215, 315), the flow of oxidizing gas (17, 17', 117, 217, 317) and the flow of solid material (8, 8', 108, 108', 208, 208', 308, 308', 308").

12. Production process (2, 102, 202, 302) of a solid catalyst material (7, 107, 207, 307, 307') in accordance with any one of the preceding claims, further **characterized in that** impregnation of the solid catalyst material (7, 107, 207, 307, 307') is carried out in a first impregnation cycle (44, 144, 244, 344) and in a second impregnation cycle (45, 245, 345),
preferably by using during the second impregnation cycle (45, 245, 345) a metal complex (15, 15', 115, 115', 215, 315) providing a second metal.

13. Production process (2, 102, 202, 302) of a solid catalyst material (7, 107, 207, 307, 307') in accordance with any one of the preceding claims, further **characterized in that** the solid catalyst material (7, 107, 207, 307, 307') for heterogene catalysis is a SCR catalyst for decomposition of nitrogen oxide molecules, preferably settled in an elongated sponge-like filter structure, or a catalyst for chemical synthesis e. g. of hydrocarbons, especially in a Fischer-Tropsch related process.

14. Apparatus (50, 150) for production of a solid catalyst material (7), preferably using a production process (2, 102, 202, 302) according to anyone of the claims 1 to 13, the apparatus (50, 150) comprising a fluidized bed reactor (53, 153) for solid particles,
comprising a reactor vessel (55, 155) and
a gas feeding filter (59), limiting a first end (56) of the reactor vessel (55), and
a gas exit filter (60), limiting a second end (57) of the reactor vessel (55),
wherein the filters are perforated with pores (61), which are smaller than a particle diameter of the solid particles to be fed to the reactor vessel (55, 155),
and in that the apparatus (50, 150) further comprises at least one gas mixing stage (63, 163) being operatively connected to the gas feeding filter (59), for controlling a mixture of a carrier gas, like an inert gas from a gas source,
either with a metal complex vapour from a metal complex source or
with an oxidizing gas,
the mixture being feedable into the reactor vessel (55, 155) and **characterized in that** the apparatus (50, 150) comprises a cooler (71) connected with the reactor vessel (55, 155) for limiting a temperature from exothermic reactions inside the reactor vessel (55, 155).

15. Apparatus in accordance with claim 14,
further **characterized in that**
the apparatus (50, 150) comprises
a feeding device (69, 169), preferably comprising an activation system (70, 170), for solid material,
and at least one of the following: a cooler (71) connected with the reactor vessel (55) or
a heater (72) connected with the reactor vessel (55),
a gas flow meter (73, 73', 73"),
a gas flow controller (74, 74', 74"), preferably comprising a timer,
whereas the gas flow meter (73, 73', 73") or the gas flow controller (74, 74', 74") are operatively connected with the mixing stage.

## Patentansprüche

1. Herstellungsverfahren (2, 102, 202, 302) eines Festkörper-Katalysatormaterials (7, 107,207,307,307')
unter Verwendung eines Festkörper-Materials (8, 8', 108, 108', 208, 208', 308, 308', 308"),
das wenigstens eine Pore oder wenigstens eine Kavität aufweist,
wobei die Pore oder die Kavität einen Durchmesser von weniger als 1 µm, vorzugsweise weniger als 50 nm, noch mehr bevorzugt weniger als 2 nm, aufweist, wie ein mesoporiges, siliziumdioxidbasiertes Material, ein Zeolith, ein metallischer Schaum, ein aluminiumoxid- oder titanoxidbasiertes Material, ein aktivierter Kohlenstoff oder Kohlenstoffmaterial mit großer Oberfläche, wie expandierter Graphit, Nano-Graphit, Graphen oder Strukturen von wenigen Graphen-Lagen,
und das einem Metallkomplex ausgesetzt wird (15, 15', 115, 115', 215, 315), wie Metallkarbonyl-Molekülen oder metallorganischen Verbindungen, der in die Pore oder Kavität gelangt,
wobei das Festkörper-Material (8, 8', 108, 108', 208, 208', 308, 308', 308") durch die folgenden Herstellungsverfahrensschritte mit Metall imprägniert wird:
- Adsorption des Metallkomplexes (15, 15', 115, 115', 215, 315) in der Pore oder in der Kavität des Festkörper-Materials (8, 8', 108, 108', 208, 208', 308, 308', 308") und
- Zersetzung des Metallkomplexes (15, 15', 115, 115', 215, 315) mittels Oxidation durch Einwirkung von oxidierendem Gas (17, 17',117, 217, 317), wie Luft, Sauerstoff, einem Halogen oder Ammoniak, vorzugsweise gemischt mit einem ersten Trägergas (18, 18', 118, 218, 318), das in die Pore oder Kavität gelangt, wobei Metall von dem Metallkomplex (15, 15', 115, 115', 215, 315) an eine Oberfläche des Festkörper-Materials (8, 8', 108, 108', 208, 208', 308, 308', 308") angelagert wird,
**dadurch gekennzeichnet, dass**
in dem Adsorptionsschritt eine Temperatur (39, 39', 139, 139') des Festkörper-Materials (8, 8', 108, 108', 208, 208', 308, 308', 308") auf eine Temperatur unterhalb einer Raumtemperatur von 25 °C reguliert wird,
Metall sich mit der Oberfläche des Festkörper-Materials (8, 8', 108, 108', 208, 208', 308, 308', 308") zumindest teilweise entlang der Pore oder der Kavität verbindet, und zumindest einige der Strukturen, die die Pore oder die Kavität einfassen, Metall als monomere Spezies oder dimere Spezies von Metall oder von Metall, gebunden an das oxidierende Gas (17, 17',117, 217, 317), dispergiert binden, vorzugsweise unter Ausbildung einer bi-funktionalisierten Katalysatoroberfläche,
wobei eine Anzahl aller monomeren Spezies größer ist als eine Anzahl aller dimeren Spezies.

2. Herstellungsverfahren (2, 102, 202, 302) eines Festkörper-Katalysatormaterials (7, 107, 207, 307, 307') nach Anspruch 1, weiter **dadurch gekennzeichnet, dass** die Adsorption des Metallkomplexes (15, 15', 115, 115', 215, 315) durch wenigstens eines der Folgenden unter Kontrolle gehalten wird:
eine Konzentration eines Metallkomplexes (15, 15', 115, 115', 215, 315) oder eine Konzentration eines ersten Metallkomplexes (123, 223, 223', 323, 323') und eine Konzentration eines zweiten Metallkomplexes (124), vorzugsweise in einem zweiten Trägergas (19, 19', 119, 219, 319),
ein Gasfluss (25, 25', 125, 125') oder ein Dampffluss (26, 126),
ein Gasdruck (28, 28', 28", 128, 128') oder ein Dampf-Partialdruck (29, 129, 229, 329),
eine Temperatur eines Gases (30, 30', 130, 130') und/oder eine Temperatur des Festkörper-Materials (8, 8', 108, 108', 208, 208', 308, 308', 308"), vorzugsweise oberhalb einer Verdampfungstemperatur eines flüssigen oder festen Metallkomplexes, und/oder
eine Flussdauer des Dampfes (32, 132, 232, 332, 332').

3. Herstellungsverfahren (2, 102, 202, 302) eines Festkörper-Katalysatormaterials (7, 107, 207, 307, 307') nach Anspruch 1 oder Anspruch 2, weiter **dadurch gekennzeichnet, dass**
die Zersetzung des Metallkomplexes durch wenigstens eines der Folgenden unter Kontrolle gehalten wird:
eine Metallkomplex-Konzentration in dem Festkörper-Material (8, 8', 108, 108', 208, 208', 308, 308', 308"),
eine Oxidationsgas-Konzentration (34, 134), vorzugsweise von weniger als 1 % eines Zersetzungsgases,
eine Oxidationsgas-Zusammensetzung (35, 135),
ein Oxidationsgas-Fluss (36, 136),
ein Oxidationsgas-Partialdruck (37, 137, 237, 337),
eine Temperatur des Oxidationsgases (38, 138) und/oder
eine Temperatur des Festkörper-Katalysatormaterials (39, 39', 139, 139'),
vorzugsweise unterhalb einer Temperatur, bei der sich der Metallkomplex zersetzt,
die in wenigstens 90 % der Masse des Festkörper-Materials (8, 8', 108, 108', 208, 208', 308, 308', 308") vorliegt,
eine Flussdauer des Oxidationsgases (40, 140).

4. Herstellungsverfahren (2, 102, 202, 302) eines Festkörper-Katalysatormaterials (7, 107, 207, 307, 307') nach einem der vorhergehenden Ansprüche, weiter **dadurch gekennzeichnet, dass**
der Metallkomplex (15, 15', 115, 115', 215, 315) ein Übergangsmetall wie Eisen, Nickel, Kobalt, Kupfer, Zink, insbesondere ein Edelmetall wie Platin oder Palladium, umfasst.

5. Herstellungsverfahren (2, 102, 202, 302) eines Festkörper-Katalysatormaterials (7, 107, 207, 307, 307') nach einem der vorhergehenden Ansprüche, weiter **dadurch gekennzeichnet, dass**
das Imprägnieren des Festkörper-Materials (8, 8', 108, 108', 208, 208', 308, 308', 308") mit Metall an einer Losgröße von Festkörper-Material (8, 8', 108, 108', 208, 208', 308, 308', 308") ausgeführt wird, insbesondere entlang gasleitender Poren oder Kavitäten, die durch das Festkörper-Material (8, 8', 108, 108', 208, 208', 308, 308', 308") führen,
eine Gesamttemperatur der Losgröße während des Imprägnierens in oder unterhalb von einem Raumtemperaturbereich gehalten wird, insbesondere auf oder unterhalb 0 °C, vorzugsweise unter -20 °C, und noch mehr bevorzugt unter -60 °C, aber noch oberhalb eines Kondensationstemperaturbereichs des Metallkomplexes (15, 15', 115, 115', 215, 315).

6. Herstellungsverfahren (2, 102, 202, 302) eines Festkörper-Katalysatormaterials (7, 107, 207, 307, 307') nach einem der vorhergehenden Ansprüche, weiter **dadurch gekennzeichnet, dass**
der Metallkomplex (15, 15', 115, 115', 215, 315) in einem gleichmäßigen und kontinuierlichen Fluss von Argon zugeführt wird, insbesondere in Mengen von 100 mg, vorzugsweise von 30 mg pro Minute und pro Gramm Festkörper-Material (8, 8', 108, 108', 208, 208', 308, 308', 308").

7. Herstellungsverfahren (2, 102, 202, 302) eines Festkörper-Katalysatormaterials (7, 107, 207, 307, 307') nach einem der vorhergehenden Ansprüche, weiter **dadurch gekennzeichnet, dass**
während einer Phase der Adsorption des Metallkomplexes (15, 15', 115, 115', 215, 315) das Festkörper-Material (8, 8', 108, 108', 208, 208', 308, 308', 308") wenigstens einmal bewegt wird.

8. Herstellungsverfahren (2, 102, 202, 302) eines Festkörper-Katalysatormaterials (7, 107, 207, 307, 307') nach einem der vorhergehenden Ansprüche, weiter **dadurch gekennzeichnet, dass**
das Festkörper-Material (8, 8', 108, 108', 208, 208', 308, 308', 308") aus Partikeln oder aus festem Material (8, 8', 108, 108', 208, 208', 308, 308', 308") besteht, das wenigstens ein Partikel umfasst,
wovon wenigstens ein Partikel einen Durchmesser von weniger als 50 µm, vorzugsweise weniger als 1 µm, in wenigstens einer Richtung aufweist.

9. Herstellungsverfahren (2, 102, 202, 302) eines Festkörper-Katalysatormaterials (7, 107, 207, 307, 307') nach Anspruch 8, weiter **dadurch gekennzeichnet, dass** wenigstens ein Partikel des Festkörper-Materials (8, 8', 108, 108', 208, 208', 308, 308', 308") an einer Aufnahme fixiert ist, wie ein Rohr, eine Wabenstruktur, einem Kordierit, oder einem metallischen Schaum.

10. Herstellungsverfahren (2, 102, 202, 302) eines Festkörper-Katalysatormaterials (7, 107, 207, 307, 307') nach einem der vorhergehenden Ansprüche, weiter **dadurch gekennzeichnet, dass**
der Adsorption des Metallkomplexes (15, 15', 115, 115', 215, 315) an dem Festkörper-Material (8, 8', 108, 108', 208, 208', 308, 308', 308") ein Herstellungsverfahrensschritt einer Oberflächenaktivierung des Festkörper-Materials (8, 8', 108, 108', 208, 208', 308, 308', 308") vorausgeht, z. B. durch Evakuieren und vorzugsweise durch Erhitzen des Festkörper-Materials (8, 8', 108, 108', 208, 208', 308, 308', 308"), insbesondere auf eine Temperatur oberhalb 100 °C.

11. Herstellungsverfahren (2, 102, 202, 302) eines Festkörper-Katalysatormaterials (7, 107, 207, 307, 307') nach einem der vorhergehenden Ansprüche, weiter **dadurch gekennzeichnet, dass**
das Imprägnieren des Festkörper-Materials (8, 8', 108, 108', 208, 208', 308, 308', 308") mit Metall kontinuierlich ausgeführt wird, insbesondere zur Bereitstellung eines Partikelflusses von Festkörper-Katalysatormaterial (7, 107, 207, 307, 307'), insbesondere unter Kontrolle des Flusses von Metallkomplex (15, 15', 115, 115', 215, 315), des Flusses von Oxidationsgas (17, 17',117, 217, 317) und des Flusses von Festkörper-Material (8, 8', 108, 108', 208, 208', 308, 308', 308").

12. Herstellungsverfahren (2, 102, 202, 302) eines Festkörper-Katalysatormaterials (7, 107, 207, 307, 307') nach einem der vorhergehenden Ansprüche, weiter **dadurch gekennzeichnet, dass**
das Imprägnieren des Festkörper-Katalysatormaterials (7, 107, 207, 307, 307') in einem ersten Imprägnierungszyklus (44, 144, 244, 344) und in einem zweiten Imprägnierungszyklus (45, 245, 345) ausgeführt wird,
vorzugsweise durch Verwendung eines Metallkomplexes (15, 15', 115, 115', 215, 315), der ein zweites Metall bereitstellt, während des zweiten Imprägnierungszyklus (45, 245, 345).

13. Herstellungsverfahren (2, 102, 202, 302) eines Festkörper-Katalysatormaterials (7, 107, 207, 307, 307') nach einem der vorhergehenden Ansprüche, weiter **dadurch gekennzeichnet, dass**
das Festkörper-Katalysatormaterial (7, 107, 207, 307, 307') für die heterogene Katalyse ein SCR Katalysator zur Zersetzung von Stickoxid-Molekülen ist, vorzugsweise festgesetzt in einer länglichen, schwammartigen Filterstruktur, oder ein Katalysator zur chemischen Synthese, z. B. von Kohlenwasserstoffen, insbesondere in einem Fischer-Tropsch-artigen Verfahren, ist.

14. Apparatur (50, 150) zur Produktion eines Festkörper-Katalysatormaterials (7), vorzugsweise mit einem Herstellungsverfahren (2, 102, 202, 302) nach einem der Ansprüche 1 bis 13,
wobei die Apparatur (50, 150) einen Fließbettreaktor (53, 153) für Festkörper-Partikel umfasst,
mit einem Reaktorbehälter (55, 155) und
einem Gaszuflussfilter (59), der ein erstes Ende (56) des Reaktorbehälters (55) begrenzt, und
einem Gasabflussfilter (60), der ein zweites Ende (57) des Reaktorbehälters (55) begrenzt,
wobei die Filter mit Poren (61) perforiert sind, die kleiner sind als ein Partikeldurchmesser der Festköper-Partikel, die dem Reaktorbehälter (55, 155) zuzuführen sind,
und dass die Apparatur (50, 150) auch wenigstens eine Gasmischungsstufe (63, 163) umfasst, die wirksam mit dem Gaszuflussfilter (59) verbunden ist, um eine Mischung eines Trägergases, wie ein Inertgas aus einer Gasquelle,
entweder mit einem Metallkomplex-Dampf aus einer Metallkomplexquelle oder mit einem Oxidationsgas unter Kontrolle zu halten,
wobei die Mischung in den Reaktorbehälter (55, 155) zuführbar ist,
**dadurch gekennzeichnet, dass**
die Apparatur (50, 150) einen Kühler (71) umfasst, der mit dem Reaktorbehälter (55, 155) verbunden ist, um eine Temperatur, hervorgerufen durch exotherme Reaktionen, im Inneren des Reaktorbehälters (55, 155) zu begrenzen.

15. Apparatur nach Anspruch 14,
weiter **dadurch gekennzeichnet, dass**
die Apparatur (50, 150)
eine Zuführung (69, 169), vorzugsweise mit einem Aktivierungssystem (70, 170), für Festkörper-Material,
und wenigstens eines der Folgenden umfasst: ein Kühler (71) verbunden mit dem Reaktorbehälter (55) oder
eine Heizung (72) verbunden mit dem Reaktorbehälter (55),
einen Gasflussmesser (73, 73', 73"),
eine Gasflusssteuerung (74, 74', 74"), vorzugsweise mit einer Zeituhr,
wobei der Gasflussmesser (73, 73', 73") oder die Gasflusssteuerung (74, 74', 74") betrieblich mit der Mischungsstufe verbunden sind.

## Revendications

1. Processus de production (2, 102, 202, 302) d'un matériau catalyseur solide (7, 107, 207, 307, 307')
qui utilise un matériau solide (8, 8', 108, 108' ; 208, 208', 308, 308', 308"),
qui a au moins un pore ou au moins une cavité,
le pore ou la cavité ayant un diamètre de moins de 1 µm, de préférence de moins de 50 nm, de manière plus préférée de moins de 2 nm,
comme un matériau à base de silice mésoporeuse, un zéolite, une mousse métallique, un matériau à base d'aluminium ou de titane, un charbon actif ou un matériau à base de carbone de surface spécifique élevée tel qu'un graphite expansé, un nanographite, un graphène ou une structure avec quelques couches de graphène, qui est exposé à un complexe métallique (15, 15', 115, 115', 215, 315), comme des composés de molécules de métalcarbonyle ou des composés organométalliques, qui entre dans le pore ou la cavité,
le matériau solide (8, 8', 108, 108', 208, 208', 308, 308', 308") étant imprégné avec du métal par les étapes de processus de production suivantes :
- adsorption du complexe métallique (15, 15', 115, 115', 215, 315) dans le pore ou dans la cavité du matériau solide (8, 8', 108, 108', 208, 208', 308, 308', 308") et
- décomposition du complexe métallique (15, 15', 115, 115', 215, 315) par oxydation due à l'exposition à un gaz oxydant (17, 17', 117, 217, 317) comme l'air, l'oxygène, un halogène ou de l'ammoniaque, de préférence mélangé à un premier gaz porteur (18, 18', 118, 218, 318), qui entre dans le pore ou la cavité, du métal du complexe métallique (15, 15', 115, 115', 215, 315) étant attaché à une surface du matériau solide (8, 8', 108, 108', 208, 208', 308, 308', 308"),
**caractérisé en ce que**
dans l'étape d'adsorption la température (39, 39', 139, 139') du matériau solide (8, 8', 108, 108', 208, 208', 308, 308', 308") est contrôlée à une température en dessous d'une température ambiante de 25°C,
du métal est lié à la surface du matériau solide (8, 8', 108, 108', 208, 208', 308, 308', 308") au moins en partie le long du pore ou de la cavité
et au moins quelques-unes des structures qui renferment le pore ou la cavité lient du métal dispersé comme espèce monomère ou espèce dimère de métal ou métal lié au gaz oxydant (17, 17', 117, 217, 317), en formant de préférence une surface du catalyseur bifonctionnalisée,
toutes les espèces monomères dépassant en nombre toutes les espèces oligomères.

2. Processus de production (2, 102, 202, 302) d'un matériau catalyseur solide (7, 107, 207, 307, 307') selon la revendication 1, **caractérisé de plus en ce que** l'adsorption du complexe métallique (15, 15', 115, 115', 215, 315) est contrôlée par au moins l'un des éléments suivants :
une concentration de complexe métallique (15, 15', 115, 115', 215, 315) ou une concentration d'un premier complexe métallique (123, 223, 223', 323, 323') et une concentration d'un second complexe métallique (124), de préférence dans un second gaz porteur (19, 19', 119, 219, 319),
un flux de gaz (25, 25', 125, 125') ou un flux de vapeur (26, 126),
une pression de gaz (28, 28', 28", 128, 128') ou une pression partielle de vapeur (29, 129, 229, 329),
une température d'un gaz (30, 30', 130, 130') et/ou
une température du matériau solide (8, 8', 108, 108', 208, 208', 308, 308', 308"), de préférence au-dessus d'une température de vaporisation d'un complexe métallique liquide ou solide et/ou une durée du flux de vapeur (32, 132, 232, 332, 332").

3. Processus de production (2, 102, 202, 302) d'un matériau catalyseur solide (7, 107, 207, 307, 307') selon la revendication 1 ou 2, **caractérisé de plus en ce que** la décomposition du complexe métallique est contrôlée par au moins l'un des éléments suivants :
une concentration de complexe métallique dans le matériau solide (8, 8', 108, 108', 208, 208', 308, 308', 308"),
une concentration de gaz oxydant (34, 134), de préférence de moins d'1% d'un gaz de décomposition,
une composition de gaz oxydant (35, 135),
un flux de gaz oxydant (36, 136),
une pression partielle de gaz oxydant (37, 137, 237, 337),
une température du gaz d'oxydant (38, 138) et/ou
une température du matériau catalyseur solide (39, 39', 139, 139'), de préférence en dessous d'une température de décomposition d'un complexe métallique dans au moins 90% de la masse du matériau solide (8, 8', 108, 108', 208, 208', 308, 308', 308"), une durée du flux de gaz oxydant (40, 140).

4. Processus de production (2, 102, 202, 302) d'un matériau catalyseur solide (7, 107, 207, 307, 307') selon l'une quelconque des revendications précédentes, **caractérisé de plus en ce que**
le complexe métallique (15, 15', 115, 115', 215, 315) comprend un métal de transition comme le fer, le nickel, le cobalt, le cuivre, le zinc, en particulier un métal précieux comme le platine ou le palladium.

5. Processus de production (2, 102, 202, 302) d'un matériau catalyseur solide (7, 107, 207, 307, 307') selon l'une quelconque des revendications précédentes, **caractérisé de plus en ce que**
l'imprégnation du matériau solide (8, 8', 108, 108', 208, 208', 308, 308', 308") avec du métal est exécutée dans un lot de matériau solide (8, 8', 108, 108', 208, 208', 308, 308', 308"), en particulier avec des pores qui transportent du gaz ou des cavités guidées à travers le matériau solide (8, 8', 108, 108' ; 208, 208', 308, 308', 308"),
une température général du lot pendant l'imprégnation est gardée dans ou en dessous d'une plage de température ambiante, en particulier à ou en dessous de 0°C, de manière plus préférée en dessous de -20°C et de manière particulièrement préférée en dessous de -60°C mais encore au-dessus d'une plage de température de condensation du complexe métallique (15, 15', 115, 115', 215, 315).

6. Processus de production (2, 102, 202, 302) d'un matériau catalyseur solide (7, 107, 207, 307, 307') selon l'une quelconque des revendications précédentes, **caractérisé de plus en ce que**
le complexe métallique (15, 15', 115, 115', 215, 315) est alimenté dans un flux régulier et continu d'argon, en particulier en quantités de 100 mg, de préférence de 30 mg par minute et par g de matériau solide (8, 8', 108, 108', 208, 208', 308, 308', 308").

7. Processus de production (2, 102, 202, 302) d'un matériau catalyseur solide (7, 107, 207, 307, 307') selon l'une quelconque des revendications précédentes, **caractérisé en ce que**,
pendant une phase d'adsorption du complexe métallique (15, 15', 115, 115', 215, 315) le matériau solide (8, 8', 108, 108', 208, 208', 308, 308', 308") est déplacé au moins une fois.

8. Processus de production (2, 102, 202, 302) d'un matériau catalyseur solide (7, 107, 207, 307, 307') selon l'une quelconque des revendications précédentes, **caractérisé en ce que**
le matériau solide (8, 8', 108, 108', 208, 208', 308, 308', 308") consiste en particules ou le matériau solide (8, 8', 108, 108', 208, 208', 308, 308', 308") comprend au moins une particule, la particule qui existe au moins ayant un diamètre de moins de 50 µm, de préférence de moins d'1 µm, dans au moins une direction.

9. Processus de production (2, 102, 202, 302) d'un matériau catalyseur solide (7, 107, 207, 307, 307') selon la revendication 8, **caractérisé de plus en ce**
**qu'**au moins une particule du matériau solide (8, 8', 108, 108', 208, 208', 308, 308', 308") est fixée à un support comme un tuyau, une structure en nid d'abeille, une cordiérite ou une mousse métallique.

10. Processus de production (2, 102, 202, 302) d'un matériau catalyseur solide (7, 107, 207, 307, 307') selon l'une quelconque des revendications précédentes, **caractérisé de plus en ce que**
l'adsorption du complexe métallique (15, 15', 115, 115', 215, 315) dans le matériau solide (8, 8', 108, 108', 208, 208', 308, 308', 308") est précédée par un étape de processus de production d'activation de surface du matériau solide (8, 8', 108, 108', 208, 208', 308, 308', 308"), par exemple au moyen de formation d'un vide et de préférence en chauffant le matériau solide (8, 8', 108, 108', 208, 208', 308, 308', 308"), en particulier à une température au-dessus de 100°C.

11. Processus de production (2, 102, 202, 302) d'un matériau catalyseur solide (7, 107, 207, 307, 307') selon l'une quelconque des revendications précédentes, **caractérisé de plus en ce que**
l'imprégnation du matériau solide (8, 8', 108, 108', 208, 208', 308, 308', 308") avec du métal est exécutée de manière continue, en particulier en fournissant un flux de particules de matériau catalyseur solide (7, 107, 207, 307, 307'), en particulier en contrôlant le flux de complexe métallique (15, 15', 115, 115', 215, 315), le flux de gaz oxydant (17, 17', 117, 217, 317) et le flux de matériau solide (8, 8', 108, 108', 208, 208', 308, 308', 308").

12. Processus de production (2, 102, 202, 302) d'un matériau catalyseur solide (7, 107, 207, 307, 307') selon l'une quelconque des revendications précédentes, **caractérisé de plus en ce que**
l'imprégnation du matériau catalyseur solide (7, 107, 207, 307, 307') est exécutée dans un premier cycle d'imprégnation (44, 144, 244, 344) et dans un second cycle d'imprégnation (45, 245, 345), de préférence en utilisant pendant le second cycle d'imprégnation (45, 245, 345) un complexe métallique (15, 15', 115, 115', 215, 315) fournissant un second métal.

13. Processus de production (2, 102, 202, 302) d'un matériau catalyseur solide (7, 107, 207, 307, 307') selon l'une quelconque des revendications précédentes, **caractérisé de plus en ce que**
le matériau catalyseur solide (7, 107, 207, 307, 307') pour une catalyse hétérogène est un catalyseur SCR pour la décomposition de molécules d'oxyde d'azote, de préférence établies dans une structure de filtre allongée de type éponge, ou un catalyseur pour une synthèse chimique, par exemple d'hydrocarbures, en particulier dans un procédé Fischer-Tropsch.

14. Appareil (50, 150) pour la production d'un matériau catalyseur solide (7), de préférence utilisant un processus de production (2, 102, 202, 302) selon l'une quelconque des revendications 1 à 13,
l'appareil (50, 150) comprenant un réacteur à lit fluidisé (53, 153) pour des particules solides,
comprenant une cuve de réacteur (55, 155) et
un filtre d'alimentation en gaz (59) délimitant une première extrémité (56) de la cuve de réacteur (55) et
un filtre de sortie de gaz (60) délimitant une seconde extrémité (57) de la cuve de réacteur (55),
les filtres étant perforés avec des pores (61) qui sont plus petits qu'un diamètre de particules des particules solides à alimenter dans la cuve de réacteur (55, 155) et en ce que l'appareil (50, 150) comprend de plus au moins un étage de mélange de gaz (63, 163) qui est connecté fonctionnellement au filtre d'alimentation en gaz (59) pour contrôler un mélange d'un gaz porteur comme un gaz inerte à partir d'une source de gaz, soit avec une vapeur de complexe métallique à partir d'une source de complexe métallique ou avec un gaz oxydant, le mélange pouvant être alimenté dans la cuve de réacteur (55, 155) et
**caractérisé en ce que**
l'appareil (50, 150) comprend un refroidisseur (71) relié à la cuve de réacteur (55, 155) pour limiter une température quant aux réactions exothermiques à l'intérieur de la cuve de réacteur (55, 155).

15. Appareil selon la revendication 14,
**caractérisé en ce que**
l'appareil (50, 150) comprend
un dispositif d'alimentation (69, 169), de préférence comprenant un système d'activation (70, 170), pour du matériau solide
et au moins l'un des éléments suivants : un refroidisseur (71) relié à la cuve de réacteur (55) ou
un chauffage (72) relié à la cuve de réacteur (55),
un débitmètre à gaz (73, 73', 73"),
un contrôleur de flux de gaz (74, 74', 74") comprenant de préférence un minuteur, le débitmètre à gaz (73, 73', 73") ou le contrôleur de flux de gaz (74, 74', 74") étant reliés fonctionnellement à l'étage de mélange.
